(19) Europäisches Patentamt
European Patent Office
Office européen des brevets

(11) **EP 2 304 339 B1**

(12) **FASCICULE DE BREVET EUROPEEN**

(45) Date de publication et mention de la délivrance du brevet:
**23.04.2014 Bulletin 2014/17**

(21) Numéro de dépôt: **09780899.2**

(22) Date de dépôt: **21.07.2009**

(51) Int Cl.:
*H01L 23/46* (2006.01)    *F04B 17/00* (2006.01)
*F25B 1/00* (2006.01)    *F28F 3/12* (2006.01)
*F25B 30/02* (2006.01)    *F04B 35/00* (2006.01)
*F04B 19/00* (2006.01)    *H01L 23/473* (2006.01)
*F25B 41/00* (2006.01)

(86) Numéro de dépôt international:
**PCT/EP2009/059389**

(87) Numéro de publication internationale:
**WO 2010/010102 (28.01.2010 Gazette 2010/04)**

(54) **DISPOSITIF DE VARIATION DE PRESSION D'UN FLUIDE PNEUMATIQUE PAR DÉPLACEMENT DE GOUTTES DE LIQUIDE ET POMPE À CHALEUR UTILISANT UN TEL DISPOSITIF**

VORRICHTUNG ZUR VERÄNDERUNG DES DRUCKS EINES PNEUMATIKFLUIDS MITTELS TROPFENVERDRÄNGUNG UND WÄRMEPUMPE MIT DERARTIGER VORRICHTUNG

DEVICE FOR VARYING THE PRESSURE OF A PNEUMATIC FLUID BY DISPLACING DROPS OF LIQUID AND HEAT PUMP USING SUCH A DEVICE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **22.07.2008 FR 0854984**

(43) Date de publication de la demande:
**06.04.2011 Bulletin 2011/14**

(73) Titulaire: **Commissariat à l'Énergie Atomique et aux Énergies Alternatives**
**75015 Paris (FR)**

(72) Inventeur: **DESPESSE, Ghislain**
**F-38120 Saint Egreve (FR)**

(74) Mandataire: **Ilgart, Jean-Christophe et al**
**BREVALEX**
**95 rue d'Amsterdam**
**75378 Paris Cedex 8 (FR)**

(56) Documents cités:
| EP-A- 1 270 066 | EP-A- 1 321 736 |
| WO-A-03/026798 | WO-A-2006/134307 |
| FR-A- 2 543 320 | FR-A- 2 841 063 |
| JP-A- 9 287 571 | US-A- 2 875 695 |
| US-A- 5 005 639 | US-B1- 6 318 970 |
| US-B1- 6 888 721 | |

• HARTSHORNE H ET AL: "Ferrofluid-based microchip pump and valve" SENSORS AND ACTUATORS B, ELSEVIER SEQUOIA S.A., LAUSANNE, CH, vol. 99, no. 2-3, 1 mai 2004 (2004-05-01), pages 592-600, XP004505821 ISSN: 0925-4005

• POLLACK M G ET AL: "ELECTROWETTING-BASED ACTUATION OF DROPLETS FOR INTEGRATED MICROFLUIDICS" LAB ON A CHIP, ROYAL SOCIETY OF CHEMISTRY, CAMBRIDGE, GB, vol. 2, no. 2, 11 mars 2002 (2002-03-11), pages 96-101, XP008038786 ISSN: 1473-0197 cité dans la demande

EP 2 304 339 B1

# Description

## DOMAINE TECHNIQUE ET ART ANTÉRIEUR

La présente invention se rapporte à un dispositif de variation de pression d'un fluide pneumatique par déplacement de gouttes de liquide, à une pompe à chaleur mettant en oeuvre un tel dispositif et un générateur d'énergie électrique mettant en oeuvre un tel dispositif.

Les pompes à chaleur de type connu, sont utilisées comme systèmes de chauffage pour des habitations, ou comme climatiseurs pour les habitations ou un système de refroidissement pour un réfrigérateur.

Une pompe à chaleur comporte un circuit fermé dans lequel circule un fluide frigorigène qui change d'état et passe d'un état liquide à un état vapeur, et dont la pression et la température varient. Le circuit comporte un condenseur, un détendeur, un évaporateur et un compresseur. Le fluide frigorigène circule entre une source froide et une source chaude, et effectue un transfert de calories entre les deux.

Le compresseur a pour objectif d'augmenter la pression et la température du fluide frigorigène.

De manière usuelle, le compresseur est une pompe à piston ou une turbine alimentée électriquement, qui crée une différence de pression suffisante pour faire passer le fluide frigorigène de son état gazeux à son état liquide.

Les pompes à chaleur, que l'on trouve par exemple dans les réfrigérateurs, présentent l'inconvénient, outre le bruit, de créer localement un gradient de pression important et donc un gradient de température important conduisant à des pertes thermiques et donc à un rendement global réduit. De plus, la structure de ce type de pompe à chaleur est figée à la construction, et il n'est pas possible de modifier son fonctionnement en fonction des variations des conditions extérieures. Leur fonctionnement n'est donc pas optimisé.

Par ailleurs, pour assurer un changement d'état avec un bon rendement, il serait préférable que la pression soit juste en dessus ou juste en dessous du seuil de changement d'état. Or, ce seuil dépend des températures des sources froide et chaude, ces températures pouvant varier. Ainsi, une marge de sécurité est prise afin d'être sûr, quelles que soient ces températures, que le seuil de pression est dépassé, ce qui a pour effet de réduire le rendement.

Le document US 6 318 970 décrit un dispositif microfluidique utilisé comme pompe, celui-ci met en oeuvre des gouttes de ferrofluide déplacées par un champ magnétique. Ce dispositif ne permet pas de maîtriser la pression d'un fluide pneumatique qui serait confiné entre les gouttes de ferrofluide.

Il existe aussi des pompes à chaleur de type Stirling, qui exploitent une instabilité mécano thermique pour convertir une différence de température en une énergie mécanique ou inversement. Il s'agit en fait d'une structure résonante qui fait faire des allers et retours à un gaz d'une chambre à une autre avec, pour chaque chambre, des conditions de pression et de température différentes. Pour avoir un bon rendement dans ce type de machine, il faut que le passage du gaz d'une chambre à l'autre soit adiabatique, c'est-à-dire que le gaz qui circule, via un canal dit « régénérateur », d'une chambre à l'autre suive le gradient de température dans le canal, tout en s'assurant que ce canal ne présente pas un volume important au regard de celui des chambres. Il faut donc que ce canal contienne des composés à forte capacité thermique pour assurer la stabilité du gradient thermique et qu'en même temps qu'il ne soit pas l'équivalent d'un pont thermique entre les deux chambres. Par ailleurs, le volume de ce régénérateur devant être limité, il faut donc trouver un compromis entre une structure longue et fine qui risque de constituer des pertes de charge importantes (pertes dues à un frottement important du gaz contre les parois de canal) et une structure large et courte qui conduit à un court circuit thermique entre les deux chambres. Ce qui rend la conception de ce type de pompe à chaleur très complexe.

C'est par conséquent de la présente invention d'offrir une pompe à chaleur dont le rendement est optimisé, et qui est capable de s'adapter aux conditions extérieures.

C'est plus généralement un but de la présente invention d'offrir un dispositif apte à faire varier la pression d'un fluide pneumatique de grande souplesse de fonctionnement et permettant une modification de la variation de pression recherchée.

## EXPOSÉ DE l'INVENTION

Les buts précédemment énoncés sont atteints pas un dispositif comportant un conduit, une pluralité de gouttes de fluide hydraulique séparées deux à deux par un fluide pneumatique, un système de déplacement des gouttes par électromouillage ou par des forces électromagnétiques, et une unité de commande du déplacement des gouttes aptes à provoquer la variation de pression du fluide pneumatique confiné entre les gouttes.

En d'autres termes, on utilise les gouttes de fluide hydraulique comme des pistons, et l'espace inter-goutte comme des chambres de compression ou de détente, le déplacement des gouttes étant obtenu par des forces électrostatiques ou des forces électromagnétiques. Les gouttes et les espace inter-gouttes forment une pluralité de pompes en série. Le fluide hydraulique étant sensiblement incompressible, le déplacement d'une goutte est converti quasi-complètement en variation de pression. Grâce à l'invention, on obtient une augmentation ou une diminution volontaire de la pression de gaz entre les gouttes de liquide. Par exemple, le dispositif comporte au moins trois volumes de gaz successifs séparés par des gouttes de liquides, la pression étant croissante ou décroissante progressivement dans les trois volumes de gaz successifs.

L'invention consiste donc à faire évoluer dans un canal une succession de gouttes liquides (eau par exemple) entre lesquelles un gaz est confiné et dont la pression peut évoluer en fonction du volume inter-goutte.

Dans le cas de la mise en oeuvre dans une pompe à chaleur, on provoque une augmentation de la pression inter-goutte lorsque les gouttes se rapprochent d'une zone où l'on veut apporter des calories et on provoque une réduction de la pression inter-goutte lorsque les gouttes se rapprochent d'une zone où l'on veut extraire des calories.

Ainsi, contrairement aux pompes à chaleurs connues, le fonctionnement de la pompe à chaleur selon la présente invention n'utilise pas un changement d'état gaz/liquide, ni un transfert de gaz entre deux chambres via un régénérateur passif, mais une variation progressive et pilotée de la pression d'un gaz dans un canal. Cette variation de pression, au lieu de se faire via une pompe ou une turbine à gaz, s'effectue très progressivement, assurant soit un déplacement quasi adiabatique du gaz, soit un transfert d'énergie thermique quasi sans pertes, c'est-à-dire sous un écart de température faible et continu.

La pression et la température sont adaptées facilement aux conditions de fonctionnement en modifiant la commande des moyens de déplacement.

En effet, chaque bulle de gaz encadrée de deux gouttes d'eau peut être placée à la pression voulue, ce qui permet de réaliser des variations quelconques de pression dans l'espace ou dans le temps.

On utilise donc des moyens de déplacement d'une pluralité de gouttes de fluide hydraulique par des forces électrostatiques ou par des forces électromagnétiques pour modifier la pression d'un fluide pneumatique confiné entre lesdites gouttes par modification du volume entre les gouttes.

La présente invention a alors pour objet un dispositif de variation de la pression d'un fluide, comportant un canal dans lequel circule une pluralité de gouttes de fluide hydraulique distantes les unes des autres, et des moyens de déplacement des dites gouttes entre une première et une deuxième extrémité du conduit, les moyens de déplacement mettant en oeuvre des forces électrostatiques ou électromagnétiques, caractérisé en ce que ledit fluide entraîné est un fluide pneumatique confiné de manière étanche entre les gouttes de fluide hydraulique, les forces appliquées par lesdits moyens de déplacement étant telles que le volume entre les gouttes augmente ou diminue progressivement selon un sens de déplacement donné provoquant respectivement une compression ou une détente du fluide pneumatique de manière progressive.

Le dispositif comporte au moins un premier, un deuxième et un troisième volume de fluide pneumatique successifs, la pression du fluide pneumatique augmentant ou diminuant progressivement du premier au troisième volume de gaz.

Dans le cas d'un déplacement au moyen de forces électrostatiques, lesdits moyens de déplacement comportent une électrode de référence avec laquelle les gouttes sont en contact permanent et des électrodes de déplacement discrètes aptes à être mises à un potentiel variable, les électrodes de déplacement étant regroupées par groupe de n électrodes se succédant dans le sens de déplacement des gouttes, l'unité de commande appliquant une commande identique à chacun des groupes pour provoquer le rapprochement ou l'écartement des gouttes dans le sens de déplacement des gouttes.

Dans un exemple de réalisation, la distance séparant les électrodes de déplacement se réduit ou augmente de manière monotone dans le sens de déplacement des gouttes, lesdits moyens de déplacement étant commandés par une tension à n phases, n étant par exemple égal à 3, dans ce cas la commande s'effectue simplement au moyen d'une alimentation triphasée.

Dans un autre exemple de réalisation, lesdites électrodes de déplacement sont de dimension variable de manière monotone dans le sens de déplacement des gouttes.

Dans le cas d'un déplacement au moyen de forces électromagnétiques, lesdits moyens de déplacement comportent une pluralité de générateurs de champ magnétique, lesdits générateurs étant regroupés par groupe de n générateurs se succédant dans le sens de déplacement des gouttes, l'unité de commande appliquant une commande identique à chacun des groupes pour provoquer le rapprochement ou l'écartement des gouttes dans le sens de déplacement des gouttes.

Dans un exemple de réalisation, la distance séparant lesdits générateurs peut se réduire dans le sens de déplacement des gouttes, lesdits moyens de déplacement étant commandés par une tension à n phases, n étant par exemple égal à 3.

Avantageusement, la surface intérieure du conduit est non mouillante vis-à-vis des gouttes, i.e. une surface hydrophobe dans le cas d'une solution aqueuse, et une surface oléophobe dans le cas d'un corps gras.

La présente invention a également pour objet une pompe à chaleur comportant au moins deux dispositifs selon la présente invention, au moins l'un comportant une unité de commande telle qu'il forme un compresseur du fluide pneumatique, au moins un autre dispositif comportant une unité de commande telle qu'il forme un détendeur du fluide pneumatique, ladite pompe comportant également au moins un échangeur thermique reliant le compresseur au détendeur, le compresseur, le détendeur, et l'échangeur thermique formant un canal unique.

Dans un mode de réalisation, l'extrémité à haute pression du compresseur étant connectée à l'extrémité haute pression du détendeur par l'intermédiaire d'un échangeur thermique d'une source chaude, et l'extrémité basse pression du détendeur étant connectée à l'extrémité basse pression du compresseur par un échangeur thermique avec une source froide, l'ensemble formé par le compresseur, le détendeur, et les échangeurs thermiques formant un canal unique, les pressions du fluide pneumatique dans les échangeurs thermiques étant telles que la température du fluide pneumatique dans l'échangeur thermique de la source chaude est supérieure à une première température, et une température du fluide pneumatique dans l'échangeur thermique de la source froide est inférieure à la deuxième température.

Les échangeurs thermiques peuvent être formés par des conduits munis de moyens de déplacement mettant en oeuvre des forces électrostatiques ou des forces électromagnétiques, chacun des ces échangeurs comportant une unité de commande pour maîtriser la pression et la température du fluide pneumatique confiné entre les gouttes.

Par exemple, la pompe à chaleur selon l'invention peut comporter une unité de commande unique pour le compresseur, le détendeur et les échangeurs thermiques, celle-ci envoyant des ordres distincts à chacun.

On peut prévoir que la pompe à chaleur comporte plusieurs dispositifs formant compresseurs, plusieurs dispositifs formant détendeurs, et plusieurs échangeurs thermiques.

De manière particulièrement avantageuse, les dispositifs formant compresseur et détendeur comportent des capteurs de flux thermique sur la paroi des conduits afin de mesurer le flux thermique entre le conduit et l'extérieur, l'unité de commande étant apte à agir sur les moyens de déplacement pour réduire la valeur absolue du flux thermique, de sorte à obtenir des compressions et détentes sensiblement adiabatiques.

Les échangeurs thermiques peuvent avantageusement comporter des capteurs de flux permettant à l'unité de commande de régler le déplacement des gouttes pour maintenir un flux thermique sensiblement constant.

La pompe à chaleur selon l'invention peut comporter des moyens de calibrages de la taille des gouttes dans le circuit et leurs dispositions relatives. Par exemple, ces moyens de calibrage comportent un réservoir muni d'un orifice d'admission des gouttes usagées et d'un orifice d'alimentation du circuit des gouttes renouvelées, et des moyens de formation de gouttes par électromouillage, le réservoir collectant les gouttes usagées, les moyens de formation de gouttes utilisant le fluide hydraulique collecté pour former de nouvelles gouttes.

Les moyens de formation de gouttes peuvent comporter une rampe émergeant du fluide hydraulique collecté et se raccordant à l'orifice d'alimentation, la rampe formant par exemple l'électrode de référence et les électrodes de déplacement étant disposées en regard.

Dans un autre mode de réalisation de pompe à chaleur, le conduit est ouvert et comporte des extrémités ouvertes communiquant soit avec la source chaude, soit avec la source froide, le fluide pneumatique subissant la détente et la compression étant de l'air pris dans la source chaude ou la source froide, et l'échangeur thermique échangeant des calories avec la source froide ou la source chaude.

Dans un autre mode de réalisation de pompe à chaleur, le conduit est ouvert et comporte des extrémités ouvertes, l'une des extrémités étant située dans la source chaude et l'autre extrémité dans la source froide, le fluide pneumatique étant l'air qui est aspiré de la source chaude ou la source froide et est relâché dans la source froide ou la source chaude respectivement, l'échangeur thermique étant situé dans la source chaude ou la source froide, de sorte qu'il y ait un échange d'air entre la source chaude et la source froide.

La présente invention a également pour objet un système de refroidissement d'une puce électronique comportant une pompe à chaleur selon l'invention, dans lequel le canal unique de la pompe à chaleur est formé en face arrière de ladite puce, le canal unique étant formé par une première spirale formant l'échangeur thermique avec la source froide formée par la puce et le compresseur, et une deuxième spirale formant l'échangeur thermique avec la source chaude formée par l'environnement extérieur et le détendeur, la première spirale entourant la deuxième spirale, le système de refroidissement comportant un radiateur sur la pompe à chaleur à l'opposé de la puce électronique, le canal unique serpentant sous le radiateur. La première spirale est telle qu'elle permet un échange thermique directement avec l'environnement extérieur, en plus de l'échange avec le radiateur.

Le canal unique peut être gravé directement dans la face arrière de la puce électronique, ou être gravé dans une plaque isolante rapportée sur la puce.

Le canal unique est avantageusement disposé dans deux plans parallèles.

La présente invention a également pour objet un dispositif de conversion d'une énergie thermique en énergie électrique comportant au moins deux dispositifs selon l'invention, l'un comportant une unité de commande telle qu'il forme un compresseur du fluide pneumatique, l'autre comportant une unité de commande telle qu'il forme un détendeur du fluide pneumatique, l'extrémité à haute pression du compresseur étant connectée à l'extrémité haute pression du détendeur par l'intermédiaire d'un échangeur thermique d'une source chaude à une première température, et l'extrémité basse pression du détendeur étant connectée à l'extrémité basse pression du compresseur par un échangeur thermique avec une source froide à une deuxième température, l'ensemble formé par le compresseur, le détendeur, et les échangeurs thermiques formant un canal unique, les pressions du fluide pneumatique dans les échangeurs thermiques étant telles que la température du fluide pneumatique dans l'échangeur thermique de la source chaude est inférieure à la première température, et la température du fluide pneumatique dans l'échangeur thermique de la source froide est supérieure à la deuxième température.

Les échangeurs thermiques peuvent être formés par des conduits munis de moyens de déplacement mettant en oeuvre des forces électrostatiques ou des forces électromagnétiques, chacun des ces échangeurs comportant une unité de commande pour maîtriser la pression et la température du fluide pneumatique confiné entre les gouttes.

## BRÈVE DESCRIPTION DES DESSINS

La présente invention sera mieux comprise à l'aide de la description qui va suivre et des dessins en annexe sur lesquels :

- la figure 1 est une représentation schématique d'un premier exemple d'un tronçon d'un conduit permettant la variation de la pression selon la présente invention utilisant les forces électrostatiques,
- la figure l'est une représentation schématique d'une goutte dans un tronçon de conduit selon la présente invention ;
- la figure 2 est une représentation schématique d'un deuxième exemple d'un tronçon d'un conduit permettant la variation de la pression selon la présenté invention utilisant les forces électrostatiques,
- les figures 3A et 3B sont des représentions graphiques des tensions de commande de la conduite de la figure 2,
- la figure 4 est une représentation schématique d'un troisième exemple d'un tronçon d'un conduit permettant la variation de la pression selon la présenté invention utilisant les forces électrostatiques,
- la figure 5 est un tableau de commande de sous groupe d'électrodes pour le conduit de la figure 4 permettant de conserver le volume inter-goutte sensiblement constante,
- la figure 6A est une représentation graphique d'une pompe à chaleur selon la présente invention,
- la figure 6B est une vue de détail de la figure 6A au niveau d'un échangeur thermique de la pompe à chaleur,
- la figure 6C est un schéma des transferts thermiques entre un échangeur thermique selon l'invention et une source chaude,
- la figure 6D est une représentation graphique du cycle de Joule-Brayton,
- la figure 7 est une représentation schématique d'un générateur de gouttes de liquide adapté à la présente invention,
- la figure 8 est une variante de réalisation d'une pompe à chaleur comportant plusieurs zones chaudes,
- les figures 9A à 9C sont différentes vues d'un système de refroidissement d'une puce électronique selon l'invention,
- les figures 10A et 10B sont des représentations schématiques d'un exemple de réalisation d'un conduit permettant la variation de la pression selon la présenté invention, utilisant les forces électromagnétiques ;
- les figures 11A et 11B sont des représentations schématique d'un autre mode de réalisation d'une pompe à chaleur selon la présente invention ;
- les figures 12A à 12C sont des représentations schématiques d'un autre mode de réalisation d'une pompe à chaleur selon la présente invention associé à un échange de fluide pneumatique entre deux zones.

## EXPOSÉ DÉTAILLÉ DE MODES DE RÉALISATION PARTICULIERS

Dans la description qui va suivre, nous allons décrire principalement des dispositifs mettant en oeuvre un déplacement par électromouillage. Nous allons donc au préalable décrire de manière générale le déplacement de goutte de liquide utilisant le principe de l'électromouillage. Cependant des dispositifs utilisant des moyens de déplacement mettant en oeuvre des forces électromagnétiques entrent de la cadre de la présente invention, comme nous le verrons par la suite.

Le fluide pneumatique confiné entre deux gouttes peut être un gaz ou un mélange de gaz, comme de l'air. A des fins de simplicité, nous désignerons ce fluide simplement par gaz, cependant tous les dispositifs s'appliquent aux mélanges de gaz.

Le déplacement par électromouillage de goutte de liquide sur un diélectrique est, par exemple décrit dans l'article de M.G. Pollack, A.D. Shendorov, R.B. Fair, intitulé « Electro-wetting-based actuation of droplets for integrated microfluidics », Lab Chip 2 (1) (2002) 96-101.

Les forces utilisées pour le déplacement sont des forces électrostatiques.

Le document FR 2 841063 décrit un dispositif mettant en oeuvre une caténaire en regard des électrodes activées pour le déplacement.

Le principe de ce type de déplacement est le suivant : une goutte repose sur un réseau d'électrodes, dont elle est isolée par une couche diélectrique et une couche hydrophobe.

Lorsqu'une électrode située à proximité de la goutte est activée, la couche diélectrique et la couche hydrophobe, entre cette électrode activée et la goutte polarisée par une électrode, agissent comme une capacité. Les effets de charge électrostatique induisent le déplacement de la goutte sur cette électrode. L'électrode peut être une caténaire, il maintient alors un contact électrique avec la goutte pendant son déplacement, comme décrit dans le document FR 2 841 063.

La goutte peut ainsi être déplacée de proche en proche, sur la surface hydrophobe, par activation successive des électrodes de la matrice d'électrodes et par guidage le long de la caténaire.

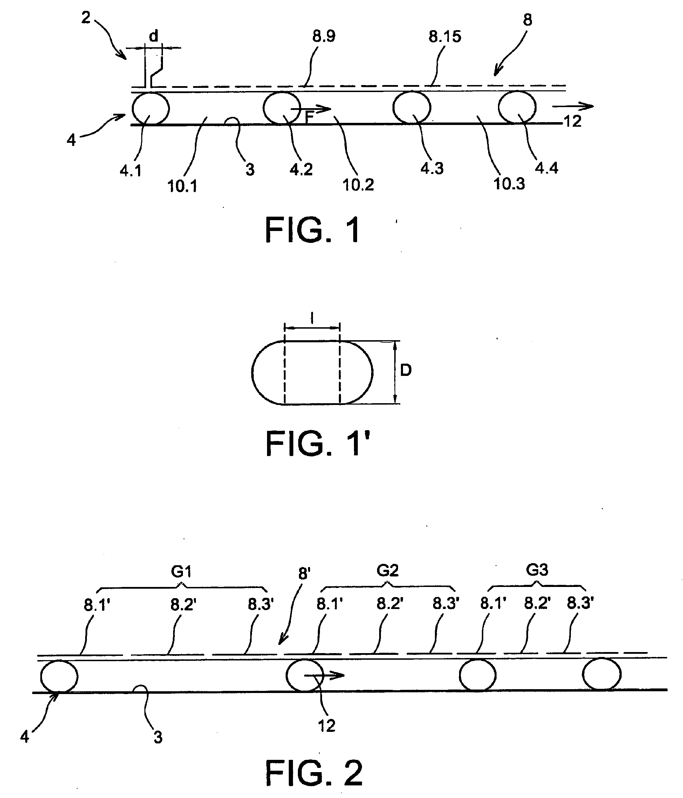

Selon la présente invention et comme cela est représenté sur la figure 1, le dispositif de variation de pression comporte un conduit 2, par exemple de forme tubulaire comportant une électrode, désignée par la suite électrode de référence 3, apte à imposer un potentiel à des gouttes de liquide 4 qui viennent en contact avec elle. Dans l'exemple représenté, cette électrode 3 est déposée sur la surface intérieure du conduit sur toute la longueur du conduit, de sorte que les gouttes restent en permanence en contact avec l'électrode. On pourrait prévoir une caténaire suspendue dans le conduit.

Le dispositif comporte également une pluralité d'électrodes discrètes 8, désignées par la suite électrodes de déplacement, déposées sur la face extérieure du conduit de sorte à ne pas être en contact avec les gouttes. Les électrodes discrètes sont disposées sur toute la longueur du conduit dessinant un chemin.

Chaque électrode 8 est reliée à une source de potentiel et peut être amené à un potentiel donné.

Le corps du conduit est avantageusement en matériau diélectrique, ainsi une goutte, le corps et une électrode 8 forme un condensateur, la mise sous tension de l'électrode 8 provoque l'apparition d'une différence de potentiel entre la goutte et l'électrode 8, et l'attraction de la goutte par l'électrode 8.

La paroi intérieure du conduit offre des propriétés hydrophobes par rapport aux gouttes de liquide, réduisant les frottements.

Les gouttes de liquide 4 sont séparées par un gaz, une paire de gouttes de liquide formant une chambre étanche remplie de gaz.

On suppose que les gouttes de liquide ont un contact étanche avec toute la paroi intérieure du conduit, confinant le gaz. Par conséquent, il n'y a pas, en fonctionnement normal, de circulation de gaz entre deux espaces inter-gouttes.

Sur la figure 1, on peut voir quatre gouttes 4.1, 4.2, 4.3 et 4.4 délimitant deux à deux des chambres 10.1, 10.2 et 10.3

Selon la présente invention, on utilise les volumes inter-gouttes 10.1, 10.2 et 10.3 comme des chambres de compression du gaz. Cette compression est obtenue par déplacement des gouttes 4.1 à 4.4 formant des pistons étanches.

A cet effet, selon la présente invention, les électrodes discrètes sont commandées individuellement pour provoquer une réduction de volume des chambres 10.1 à 10.3.

Dans l'exemple représenté, le conduit a un diamètre sensiblement constant, la variation de volume étant alors obtenue par variation de la distance inter-goutte. Il est bien entendu que le conduit peut offrir un diamètre variable et offrir, par exemple une forme évasée ou se rétrécissant. Dans ce cas, on peut envisager de conserver une distance inter-goutte sensiblement constante, la variation de pression étant obtenue directement par la variation de section du conduit. La variation de pression peut aussi être obtenue à la fois par la variation de section du conduit et par variation de la distance entre les gouttes.

Nous allons décrire une étape de compression du gaz contenu dans les chambres 10.1 à 10.3.

Dans cet exemple de réalisation, les électrodes discrètes sont toutes de même taille et écartées d'un pas constant d, et la section des gouttes est égale à celle du conduit et est égale à S.

On suppose que la pression du fluide dans les chambres est initialement égale à P.

L'électrode 8.9 est activée, la goutte 4.2 se déplace alors d'une distance D dans le sens de la flèche 12, le volume de la chambre 10.2 est réduit, d'un volume égale à S*D.

En considérant que la force électrostatique appliquée à la goutte est égale à F, celle-ci étant sensiblement incompressible, elle transmet cette force au gaz, la pression dans la chambre 10.1 est désormais égale à :

$$P10.2 = P + F/S$$

Ensuite, en activant l'électrode 8.15, la goutte 4.3 se déplace de d, la pression dans la chambre 10.3 est égale à :

$$P10.3 = P10.2 + F/S$$

$$P10.3 = P + 2F/S.$$

il y a donc eu une augmentation de la pression entre le gaz de la chambre 10.1 et le gaz de la chambre 10.3.

Dans l'exemple décrit, seules trois chambres ont été représentées, mais il est bien-entendu que le dispositif selon l'invention comporte un grand nombre de chambres délimitées par deux gouttes de liquide. En utilisant au moins trois chambres inter-gouttes, on obtient, en agissant de proche en proche une augmentation progressive de la pression du gaz entre deux gouttes. On obtient également une augmentation progressive de la température.

Toutes les gouttes sont déplacées et cheminent dans le conduit. L'alimentation en gouttes à une extrémité d'admission du dispositif est continue. Par conséquent, une circulation de gaz et une compression de celui-ci s'effectue en continue. On obtient alors, à la deuxième extrémité du tube, un fluide sous pression comprimé en continu.

La valeur de la force électrostatique F peut être ajustée, non seulement en ajustant la différence de potentiel entre l'électrode de référence et les électrodes de déplacement, mais également au moyen de la valeur de l'avance de phase des électrodes de déplacement activées par rapport à la position actuelle de la goutte au moment de l'activation des électrodes de déplacement.

En outre, ce système pour augmenter la pression est silencieux, puisqu'aucune pièce mécanique n'est en mouvement. En outre il n'y a pas d'usure.

Dans cette réalisation, chaque électrode de déplacement est commandée individuellement, elle présente alors l'avantage d'être très flexible lorsque le conduit comporte un nombre important d'électrodes. En effet, plus le nombre d'électrodes est important, plus il est aisé de positionner chaque goutte précisément, ce qui permet donc de mieux contrôler la pression et la température. Pour obtenir une telle commande individuelle, on utilise autant de commandes indépendantes que d'électrodes. Dans le cas d'un très grand nombre d'électrodes, la réalisation électronique peut devenir très complexe.

De manière avantageuse et comme nous le verrons par la suite, le dispositif selon la présente invention est particulièrement adapté pour effectuer des phases de compression et de détente adiabatiques, puisqu'il permet de régler aisément la température du gaz, cette régulation pouvant être faite en fonction de la température extérieure.

Nous avons décrit la compression du gaz, mais il est bien entendu que le dispositif est tout aussi adapté à la détente de gaz, i.e. la diminution de sa pression, en commandant les électrodes de déplacement de sorte à provoquer une augmentation du volume des chambres inter-gouttes.

Sur la figure 2, on peut voir un deuxième exemple de réalisation d'un dispositif de variation de pression, offrant une commande simplifiée.

Le dispositif de la figure 2 comporte une électrode de référence 2, et des électrodes de déplacement 8'. Dans cet exemple, les électrodes ont des tailles différentes, celles-ci sont séparées d'un pas qui peut varier, permettant, au moyen d'une simple alimentation en courant multiphase, de provoquer une variation de pression.

Les électrodes 8' sont réparties en groupe d'électrodes G1, G2, G3 de tailles différentes, dans l'exemple représenté, les électrodes sont de tailles décroissantes dans le sens de la flèche 12, plus particulièrement leur dimension dans le sens de la flèche 12 est décroissante.

Chaque groupe comporte une électrode apte à être activée simultanément avec une électrode de chaque autre groupe.

Dans l'exemple représenté, la commande est du type triphasée, chaque groupe G1, G2, G3 comporte trois électrodes 8.1', 8.2', 8.3', toutes les électrodes 8.1', sont connectées ensemble, toutes les électrodes 8.2' sont connectées ensemble et toutes les électrodes 8.3' sont connectées ensembles.

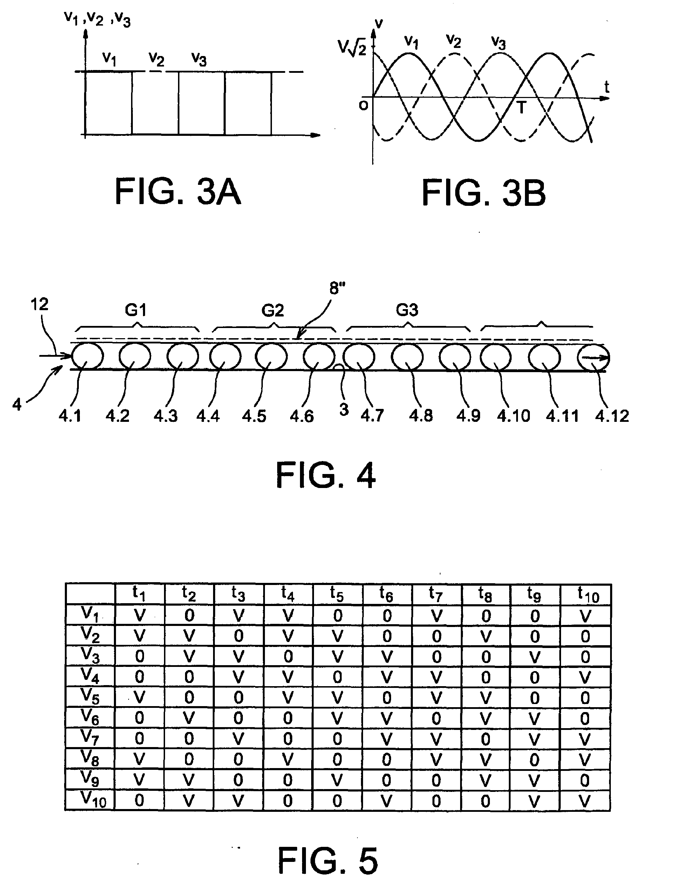

Sur la figure 3A, on peut voir un graphique représentant une commande triphasée en tension V1, V2, V3 en fonction du temps, en forme de créneaux.

Sur la figure 3B, on peut voir un graphique représentant une commande triphasée en tension V1, V2, V3 en fonction du temps, en forme de sinusoïde.

Nous allons maintenant expliquer le fonctionnement de ce dispositif.

On considère que les gouttes se positionnent sous les électrodes présentant la différence de potentiel par rapport à cette de l'électrode de référence en absolue la plus élevées. Ainsi, lorsque toutes les électrodes 8.1' sont activées les gouttes positionnées en dessous des électrodes 8.1' sont attirées par les électrodes 8.2', et se positionnent sous les électrodes 8.2'. Ensuite, lorsque les électrodes 8.3' sont activées, les électrodes passent sous les électrodes 8.3'. Et enfin lorsque les électrodes 8.1' sont à nouveau activées, les gouttes se positionnent sous les électrodes 8.1'.

Du fait de la décroissance de la taille des électrodes, et éventuellement du pas entre les électrodes, de manière monotone, il y a une diminution du volume inter-goutte, le gaz est alors comprimé.

Comme pour le dispositif de la figure 1, la circulation des gouttes est continue, ainsi que la compression du fluide.

Pour obtenir une réduction de la pression, il suffit de déplacer les gouttes dans le sens des électrodes croissantes.

Les zones où les électrodes sont longues et espacées, l'espace inter-goutte est important et la pression et/ou la température basse et, au contraire les zones où les électrodes sont étroites et rapprochées, l'espace inter-goutte est réduit et la pression et/ou la température est (sont) élevée(s).

Ce dispositif présente l'avantage d'avoir une commande très simple, en effet une simple commande en courant ou tension triphasée permet de faire fonctionner ce dispositif.

Il est bien entendu que ce dispositif peut fonctionner avec une commande comportant un nombre de phases autre que 3, le nombre d'électrodes par groupe étant proportionnel au nombre de phases.

Ce dispositif est particulièrement adapté par exemple à la réalisation de réfrigérateurs. Puisque la longueur du conduit est constante pour un type de réfrigérateur; il peut être construit en grande série, ce qui abaisse son coût et sa commande est simplifiée.

On peut également envisager d'avoir des électrodes de même taille écarter d'une distance augmentant ou diminuant, ce qui évite alors d'avoir des électrodes qui deviennent plus longue que les gouttes qu'elles déplacent.

Sur la figure 4, on peut voir un troisième exemple de réalisation d'un dispositif de variation de pression selon la présente invention.

Dans l'exemple représenté, le dispositif comporte un conduit 2, une électrode de référence 4, et des électrodes de déplacement 8". Les électrodes de déplacement sont toutes de même taille et espacées d'un pas constant.

Les électrodes sont commandées par groupe, G1, G2, G3,.... Dans l'exemple représenté, les groupes comportent dix électrodes, les groupes se succédant le long du conduit.

A chaque instant, une commande identique est appliquée à chacun des groupes. Une commande consiste à appliquer une tension à certaine électrode et pas à d'autres afin d'écarter ou de rapprocher des gouttes au sein d'un même groupe pour provoquer une compression ou une détente respectivement.

Pour changer la distance inter-goutte et/ou la pression le long du canal, par exemple pour faire évoluer sa température, il suffit de commander chaque groupe $G_1$ de n électrodes se succédant avec un motif différent comme par exemple en modifiant le nombre de moyen de gouttes par groupe. Pour cela, si on souhaite réduire le volume inter-goutte, on prévoit dans un groupe une activation alternée de 10/3 électrodes (cf. tableau de la figure 5), ce qui fait 3,33 gouttes par groupe, et dans la groupe suivant, on prévoit une activation alternée des électrodes pairs et impairs, ce qui fait une goutte en moyenne toutes les deux électrodes. Il y a donc bien une diminution du volume inter-goutte.

A titre d'exemple, on peut donner les dimensions suivantes pour un dispositif selon l'invention :

Le diamètre intérieur du canal peut faire par exemple 5 mm, le diamètre des gouttes à l'état naturel (forme sphérique) peut faire 6 mm ; lorsque la goutte est introduite dans le canal, elle prend une forme allongée (représentée sur la figure 1') de type cylindre de diamètre D de 5 mm , l'excédant de diamètre initial assurant une pression minimale des gouttes sur la paroi du canal pour assurer l'étanchéité, puisque la goutte exerce un effort sur la paroi pour tenter de reprendre sa forme sphérique. La taille des électrodes peut être de l'ordre de la longueur de la partie de la goutte en contact avec le canal. Dans ce cas, cette longueur l est de l'ordre de 2.4 mm. Les formes des électrodes de déplacement peuvent être diverses. Ces électrodes peuvent former des bagues complètes, i.e. un tube de longueur 2,4 mm dans le cas d'une électrode 3 de type filament central. Dans le cas ou l'électrode 3 est déposée d'un coté du canal, les électrodes de déplacement peuvent avoir la forme d'une portion d'un tube coupé dans le sens de sa longueur

Le dispositif selon la présente invention est particulièrement adapté pour réaliser des pompes à chaleur. En effet, le dispositif permet de réaliser, simplement un compresseur et un détendeur. En outre, il peut être utilisé en tant qu'échangeur thermique avec une source chaude et une source froide.

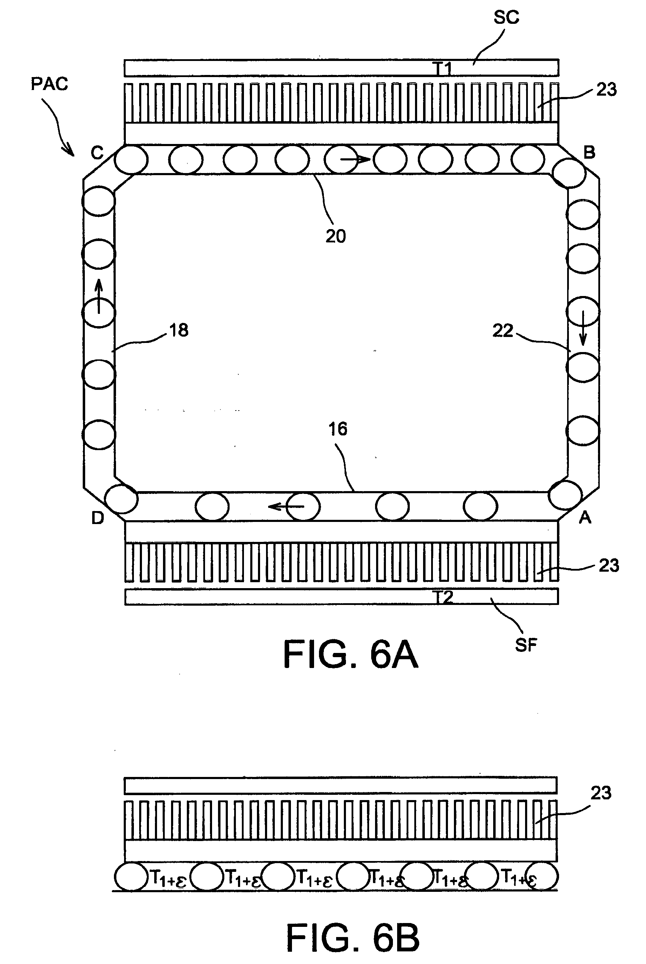

Sur la figure 6A, on peut voir représentée de manière schématique une pompe à chaleur PAC selon l'invention.

La pompe à chaleur PAC comporte, connectés en série, un échangeur thermique 16 avec une source froide SF s'étendant en A et D, un compresseur 18 entre D et C, un échangeur thermique 20 entre C et B avec une source chaude SC et un détendeur 22 entre B et A.

Le compresseur 18 et le détendeur 22 selon la présente invention sont réalisés conformément à l'un des dispositifs décrits en relation avec les figures 1 à 4.

Les échangeurs thermiques 16 et 20 comportent également un conduit avec une électrode de référence et des électrodes de déplacement, les électrodes de déplacement étant commandées de sorte à permettre un maintien de la distance inter-goutte sensiblement constante. 23 désignent des radiateurs des échangeurs thermiques.

Le dispositif de la figure 4 en relation avec la commande représentée dans le tableau de la figure 5 est adapté pour former de tels échangeurs. La commande de la figure 5 est bien entendu un exemple, toute autre commande adaptée peut convenir.

Le tableau de la figure 5 représente la commande en tension de chaque électrode d'un groupe en fonction du temps. Par exemple, à l'instant t1, les électrodes V1, V2, V5, V8 et V9 sont au potentiel V, tandis que les électrodes V3, V4, V6, V7 et V10 sont à un potentiel nul. Cette commande est appliquée à tous les groupes.

Les gouttes de liquide sont numérotées de 4.1 à 4.12.

A l'instant t1, les gouttes ont la position telle que représentée sur la figure 4.

Lorsque que la commande à l'instant t2 est appliquée :

- la goutte 4.1 se déplace vers l'électrode V3,
- la goutte 4.2 se déplace vers l'électrode V6
- la goutte 4.3 se déplace vers l'électrode V10,

et ainsi de suite avec les autres gouttes.

On constate que les distances entre les gouttes 4.1, 4.2 entre 4.2 et 4.3... n'ont pas varié.

Lorsqu'on applique les commandes aux instants t3 à t10, on conserve les distances inter-gouttes sensiblement constantes.

L'exemple de réalisation de la figure 4 présente l'avantage de permettre de réaliser toute la pompe à chaleur avec une seule structure de dispositif, seules les commandes changeant suivant la fonction de chacune des portions. Il ne s'agit alors que d'une adaptation électronique.

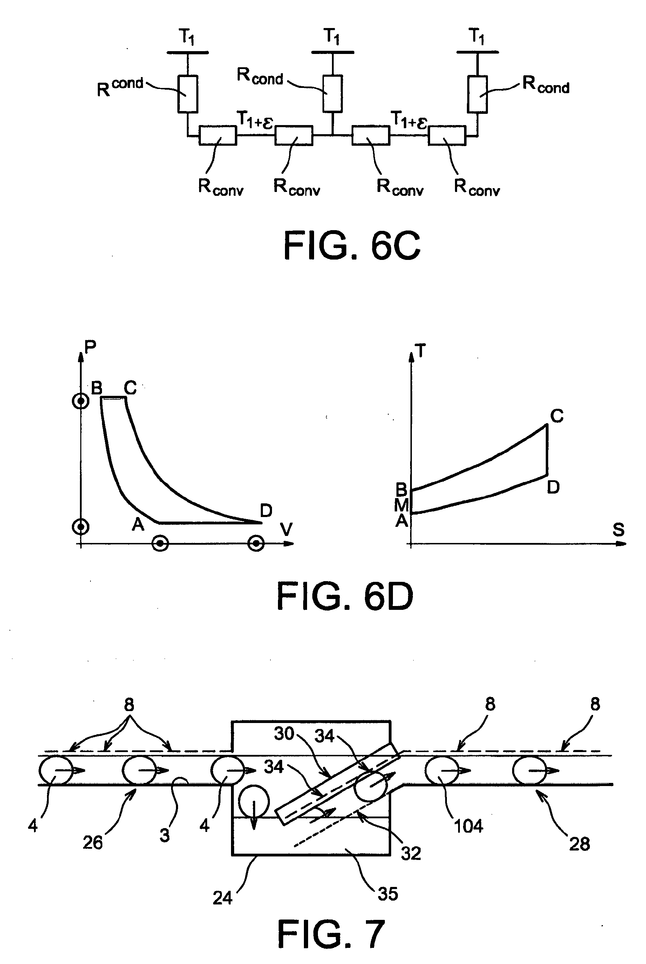

Nous allons maintenant décrire le fonctionnement de chacune des zones de la pompe à chaleur en fonction du cycle thermodynamique de Joule-Brayton représenté en figure 6D.

Du point D au point C, il s'agit d'une phase de compression. Il y a une montée progressive de la pression du gaz piégé entre les gouttes de liquide. Chaque goutte est en fait soumise à une force électrostatique dans la direction D vers C, ce qui a pour effet de soumettre chacun des espaces inter-gouttes se trouvant en C à l'effort cumulé appliqué sur toutes les gouttes se trouvant en amont dans le sens de D vers C.

Sur le cycle, il s'agit d'une étape à entropie constante avec augmentation de la pression et de la température du gaz. Si la section de la pompe formant compresseur a une longueur suffisamment grande, on peut considérer que le flux thermique entre C et D dû à la conductivité thermique du conduit peut être considéré comme négligeable, la pression inter-goutte est alors telle que la température du gaz suit le gradient thermique du conduit, la montée en pression peut donc être considérée comme étant adiabatique, i.e. sans échange de calories avec l'extérieur ou presque.

En choisissant un tube long, la distance entre le gaz à basse température et celui à haute température est importante, le risque que le conduit lui-même forme un court-circuit thermique est donc réduit. On peut choisir avantageusement un matériau faiblement conducteur thermique pour réduire encore le risque de court-circuit thermique.

Le gaz a été échauffé, cette quantité de chaleur stockée va alors être utilisée pour réchauffer l'environnement extérieur formé par la source chaude SC. Le gaz toujours confiné entre deux gouttes de liquide, arrive dans la zone C-B formant l'échange thermique 20. Du point C au point B, il y a ajustement de la pression de façon à évacuer de manière continue des calories vers la source chaude SC à la température T1.

De manière générale, pour avoir un flux thermique en direction de la source chaude SC, on crée entre la source chaude SC et la source froide SF, qui est à une température T2, un écart de température supérieur à celui réellement souhaité au final. En fait, on souhaite atteindre un écart égal à T1-T2, mais on impose un écart égal à T1-T2+2ε, en imposant au gaz du côté de la source chaude, une température égale à T1+ε, et du côté de la source froide une température égale à T2-ε.

Or, le rendement théorique est inversement proportionnel à l'écart de température généré. Donc il est préférable d'avoir une valeur de ε petite.

Grâce à l'invention, on peut maintenir le gaz contenu dans les espaces inter-gouttes à une température T1+ε légèrement supérieure à T1, ε étant petit, et ceci par ajustement de la pression, de façon à ce qu'il y ait un flux thermique continu sur l'ensemble de la longueur de l'échangeur, comme cela est représenté sur la figure 6B. Sur la figure 6C, on peut voir une représentation schématique des transferts thermiques entre les gouttes et le gaz et entre le gaz et le conduit, Rconv désigne les résistances de convection thermique entre le gaz et les gouttes 4 et Rcond désigne les résistances de conduction thermique entre le gaz et le conduit.

Il est préférable de maintenir un différentiel de température sensiblement constant et faible sur toute la longueur de l'échangeur thermique, ce qui maximise le flux global tout en limitant l'écart de température ε, qui est une source de pertes énergétiques.

L'étape CB correspond à une étape à pression constante.

Du point B au point A, on provoque la détente du gaz. La détente est obtenue par éloignement des gouttes de liquide, la température du gaz suit le gradient de température du conduit assurant un transfert quasi adiabatique de la source chaude SC à la température T1 à la source froide SF à la température T2 du gaz, de manière similaire à la montée en pression entre D et C. Pour cela, l'unité de commande adapte le déplacement des gouttes pour modifier la pression de sorte que, la température du gaz soit égale ou proche de celle de l'environnement extérieur.

Le fluide entre ensuite à nouveau dans une étape d'échange thermique pour récupérer des calories à la source froide SC du point A au point D, la pression du gaz est ajustée pour collecter de manière continue des calories en provenance de la source froide SF. Comme pour la zone CB, il est préférable de maintenir le gaz confiné entre les gouttes à une température T2- e légèrement inférieure à T2 par ajustement de la pression, de façon à ce qu'il y ait un flux thermique continu sur l'ensemble de la longueur de l'échangeur, ce qui permet de maximiser le flux globale tout en limitant l'écart de température ε. Selon la présente invention, en considérant une source froide à température constante, ce qui est généralement le cas pour les pompes à chaleur géothermiques, chaque position correspond à une température et une pression donnée.

Le gaz est alors prêt à subir une nouvelle phase de compression entre D et C, comme expliquer précédemment.

Il est bien entendu que ce circuit peut être utilisé pour rafraîchir les pièces d'une habitation, pour cela il suffit de modifier les commandes pour que la zone DC fonctionne en détendeur et la zone BA fonctionne en compresseur, afin d'absorber de la chaleur au niveau de la source à la température T1 et de l'évacuer au niveau de la source à la température T2.

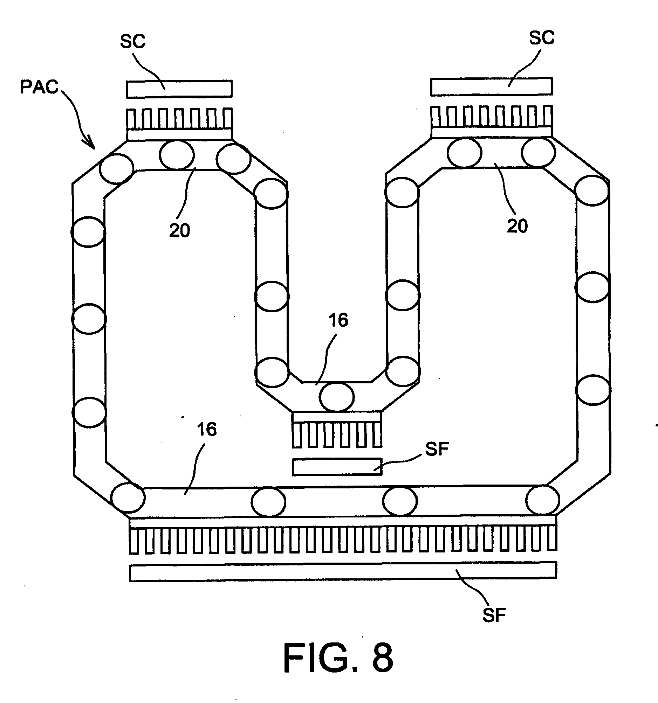

Sur la figure 8, on peut voir un exemple de pompe à chaleur selon la présente invention comportant plusieurs échangeurs thermiques 2 avec des sources chaude SC et plusieurs échangeurs thermiques 16 avec des sources froides SF, ce qui permet, dans le cas d'une utilisation comme chauffage d'une maison, de faire circuler le conduit dans plusieurs pièces que l'on souhaite chauffer à des températures différentes. Chacune des pièces forme une source chaude et le jardin forme une source froide. Le conduit peut circuler dans le jardin, ou plus généralement dans le sol, entre chaque pièce à chauffer. Dans ce cas, la pompe à chaleur comporte plusieurs compresseurs et plusieurs détendeurs.

L'adaptation de la température de chaque pièce est obtenue, soit lors de la fabrication, en ajustant les tailles des électrodes, leur espacement et leur forme comme dans le dispositif selon le deuxième exemple, soit par ajustement de la commande à la pose de la pompe à chaleur.

Dans les exemples de pompe à chaleur représentés, le circuit est fermé, les gouttes de liquide et le fluide pneumatique sont réutilisés à chaque cycle.

On peut prévoir de renouveler le liquide et le gaz à chaque cycle, ou après un certain temps de fonctionnement. Il peut, en outre, arriver que certaines gouttes de liquide se regroupent, que des gouttes s'évaporent ou s'écartent de leur position. Ces modifications ont, pour conséquence, de réduire le nombre des espaces inter-gouttes, de modifier le volume des espaces inter-gouttes, la pompe à chaleur est alors moins performante car sa commande est moins adaptée au nouvelles caractéristiques de la pompe.

On prévoit alors avantageusement d'insérer dans le circuit de la pompe des moyens pour rétablir les caractéristiques initiales de la pompe à chaleur, c'est-à-dire un recalibrage de la pompe.

Pour cela, on prévoit des récolter les gouttes de liquide, puis de générer de nouvelles gouttes à partir du liquide récolté, ces nouvelles gouttes ayant la taille requise et espacées les unes des autres suivant une distance donnée.

Sur la figure 7, on peut voir un exemple de réalisation de tels moyens pour rétablir les caractéristiques de la pompe, comportant un réservoir 24 connecté à un conduit 26 d'arrivée des gouttes, dites gouttes usagées, un conduit d'évacuation 28 des gouttes reformées, dites gouttes neuves.

Le conduit 26 comporte des moyens de déplacement par électromouillage pour amener les gouttes dans le réservoir 24, celles-ci sont amenées jusqu'à l'extrémité du conduit 26 et tombent par gravité dans le réservoir 24.

Des moyens 30 pour générer des gouttes neuves de liquide sont prévus dans le réservoir. Ces moyens sont du type à électromouillage, et comporte une électrode de référence 32 et des électrodes de déplacement 34. Ces moyens sont conformés en rampe émergeant du liquide collecté 35, pour acheminer les gouttes 104 ainsi formées jusqu'au conduit d'évacuation 28. L'électrode de référence est, par exemple une grille sur laquelle vont cheminer les gouttes neuves. Les moyens de génération par électromouillage sont avantageusement confondus avec ceux destinés à déplacer les gouttes dans la pompe à chaleur. L'air ou un autre gaz est automatiquement confiné entre deux gouttes de liquide lors de leur formation. Les gouttes ont la bonne taille et espacées d'une distance donnée.

Les moyens de génération de gouttes neuves sont avantageusement insérés dans le circuit de la pompe, dans une zone où il n'y a pas de variation de pression, par exemple du côté des sources à T1 ou T2. Dans ce cas, le réservoir peut jouer en même temps un rôle de complément d'échangeur thermique. Il peut également être disposé dans une zone à pression ambiante, si celle-ci existe, pour faciliter la maintenance, pour permettre l'ouverture du dispositif de recyclage sans risquer de faire rentrer ou sortir du gaz/liquide sous l'effet d'une surpression ou d'une sous-pression. Il est à noter que le système peut être globalement en forte surpression ou forte sous-pression par rapport à la pression ambiante et donc n'avoir aucune zone à pression ambiante.

A titre d'exemple, la pression moyenne dans le circuit peut être comprise entre la pression ambiante et dix fois la pression ambiante. Par ailleurs, l'écart de pression dans le circuit peut être d'un facteur deux entre la pression la plus basse et la pression la plus haute.

Comme cela a été mentionné précédemment, on souhaite effectuer des phases de compression et de détente adiabatique, i.e. sans échange de chaleur avec l'extérieur, ce qui revient à avoir un flux d'échange thermique nul entre l'intérieur du conduit et l'environnement extérieur.

L'environnement extérieur peut être, par exemple un mur dans le cas d'une pompe à chaleur utilisée comme moyen de chauffage.

Pour cela, on utilise pour fabriquer le conduit un matériau à faible conductivité thermique.

Grâce à la présente invention, il est possible de réduire le flux d'échange thermique par commande des gouttes, pour cela on adapte la température du gaz à la température extérieur pour que le flux d'échange thermique soit nul. Ceci est facilement réalisable en ajustant la pression du fluide pneumatique au moyen de la commande des électrodes de déplacement.

Par exemple, on utilise des capteurs de flux d'échange thermique pour mesurer la valeur du flux d'échange thermique entre le conduit et l'environnement extérieur tout le long du conduit, ces mesures sont envoyées à l'unité de commande, qui, en fonction des valeurs du flux, peut modifier la commande des électrodes de manière individuelle ou par groupe afin de faire tendre la valeur du flux vers zéro.

Par exemple, un mur séparant l'extérieur de l'intérieur d'une maison connaît un gradient thermique. Ce mur est traversé par la pompe à chaleur, le partie de la pompe à chaleur traversant le mur est par exemple le compresseur ou le détendeur, puisque les échangeurs thermiques se trouvent soit à l'intérieur, soit à l'extérieur de la maison. Comme nous l'avons mentionné ci-dessus, il est préférable que la compression et la détente soient adiabatiques, i.e. sans flux thermique vers l'extérieur.

Grâce à l'invention et à la mise en oeuvre de capteurs de flux thermique, on peut ajuster la pression pour le gradient de température dans le conduit soit très proche, voire identique à celui que connaît le mur, i.e. que la température du gaz en tout point du conduit soit égale ou très proche de la température dans le mur.

On peut également utiliser de tels capteurs de flux dans les zones d'échange thermique entre C et B et A et D, afin de permettre à l'unité de commande de fixer le flux à une valeur de consigne, avantageusement une valeur faible mais constante tout le long de l'échangeur thermique.

Le liquide formant les gouttes peut être de l'eau ou tout autre liquide. Dans le cas d'une pompe à chaleur, où la source froide est la terre ou l'air, on peut prévoir un liquide dont la température de solidification est relativement basse, inférieur à 0°C. Le gaz présente de préférence un bon coefficient d'échange thermique, celui-ci peut être de l'air ou un gaz unique.

Dans le cas d'une pompe à chaleur, les conduits présentent par exemple un diamètre de 5 à 10 mm, et peuvent être réalisés en cuivre ou en matériau plastique. Un isolant thermique peut être rapporté sur le conduit dans les zones où on ne souhaite pas avoir d'échange thermique avec l'extérieure, i.e. les zones de compression ou de détente par exemple. Dans le cas d'un canal en matériau conducteur, comme par exemple le cuivre, les électrodes sont placées à l'intérieur du canal et sont isolées électriquement de ce canal. Pour cela, il est possible :

- de déposer à l'intérieur de ce canal une première couche isolante, de type plastique ou autre dont l'épaisseur est comprise entre quelques μm et 1 mm,
- de déposer ensuite sur cette couche isolante les électrodes avec leur piste d'accès électrique permettant leur commande, et
- de déposer sur les électrodes une couche isolante électrique ; celle-ci est de préférence non mouillante vis-à-vis du liquide envisagé, i.e. hydrophobe pour une solution aqueuse ou oléophobe, vis-à-vis d'un corps gras.

Le rendement d'une telle pompe à chaleur selon la présente invention mettant en oeuvre des déplacements par électromouillage, dépend surtout du rapport entre les efforts électrostatiques qui sont appliqués et les efforts de frottement qui s'exercent entre les gouttes et la paroi du canal. C'est-à-dire le rapport entre le travail électrostatique apporté par rapport au travail mécanique dissipé sous forme de frottement. Pour la présente invention, on estime qu'on peut obtenir des efforts de frottement quatre fois inférieurs aux efforts électrostatiques applicables, des rendements proches de 75% du rendement théorique de Carnot peuvent être attendus. La figure 6 de l'article « Dynamics of droplet transport induced by electrowetting actuation », Roland Bavière, Jérôme Boutet, Yves Fouillet, in Microfluid Nanofluid, Volume 4, Number 4 / avril 2008, *DOI 10.1007/s10404-007-0173-4* qui montre qu'il faut, dans le cas des dimensions données, 10 mN/m pour contrer les efforts de frottement et qu'il est possible de produire jusqu'à 40 mN/m.

Les pertes thermiques liées à la conduction thermique du canal qui relie les zones chaudes et froides sont à prendre en compte, cependant en utilisant un canal relativement long, les pertes thermiques associées peuvent être considérées comme négligeables. Les pertes associées à la chute de température ε au niveau des échangeurs thermique sont également à considérer, mais ces pertes sont liées au principe de fonctionnement d'un échangeur thermique. Par ailleurs, grâce à l'invention, la chute de température ε est faible et est ajustable, les pertes sont donc réduites.

Le transfert d'énergie s'effectue principalement par la variation progressive et pilotée d'un gaz. Cependant, on peut imaginer que les gouttes liquides changent partiellement d'état (de l'ordre de quelques pourcents de leur volume) et passent de l'état liquide à l'état gazeux et inversement en fonction des conditions pression/température dans les différentes zones du canal. Il est bien entendu que les changements d'état d'une partie du volume des gouttes est telle qu'ils ne provoquent pas une rupture de l'étanchéité entre deux volumes de gaz. Cet effet peut être exploité pour améliorer la quantité de calories transférées ; dans les zones de faible pression, il y a vaporisation d'une partie du volume des gouttes et une absorption de chaleur, et dans les zones de forte pression, il y a condensation du volume de goutte évaporé et libération de chaleur.

Nous avons décrit des exemples de réalisation dans lesquels le déplacement des gouttes est obtenu par des efforts électrostatiques, mais on peut aussi envisager de les faire se déplacer via des forces électromagnétiques. Pour cela, on utilise des gouttes qui ont des propriétés ferromagnétiques et qui peuvent alors être sensibles au champ magnétique, par exemple des gouttes formées avec un liquide magnéto-rhéologique. On peut alors prévoir des moyens pour générer un champ magnétique réparti tout au long du canal, par exemple des bobinages en remplacement des électrodes é pour faire progresser les gouttes. Cette structure a l'avantage de ne pas présenter de risque de claquage diélectrique. Il est bien entendu que les configurations des exemples représentés sur les figures 1 à 3 s'appliquent aux moyens de déplacement par les forces électromagnétiques.

Dans le cas d'un déplacement par application de forces électrostatique, l'application d'un effort revient à placer une certaine charge électrique sur les électrodes. Dans le cas d'un déplacement par application de forces électromagnétiques, cela revient à appliquer un certain courant électrique dans les bobinages.

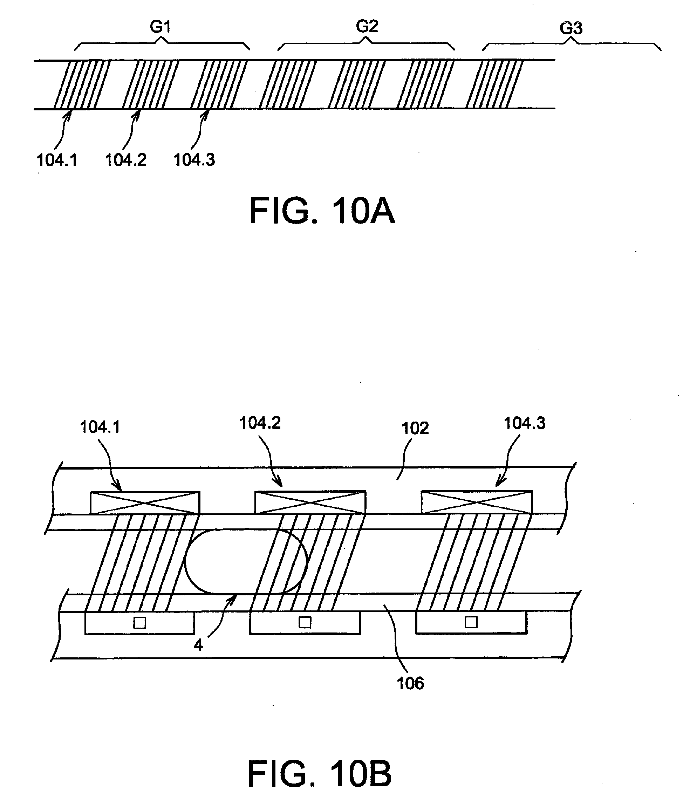

Sur les figures 10A et 10B, on peut voir une représentation schématique d'un exemple de réalisation d'un dispositif utilisant les forces électromagnétiques.

Ce dispositif comporte un canal 102 dont la surface intérieure 106 est non mouillante par rapport au liquide des gouttes considéré, le liquide étant un ferrofluide, des bobinages 104.1, 104.2, 104.3 répartis le long du canal. Le canal peut être en matériau ferromagnétique. Dans ce cas, les bobinages sont en groupes G1, G2, G3... de trois électrodes comme dans l'exemple de la figure 2, une commande par une alimentation triphasée peut alors être appliquée. Par groupe, les bobinages sont soit de taille variable, soit espacés d'une distance variable, de manière similaire aux exemples décrits dans le cas d'un déplacement par application de forces électrostatiques.

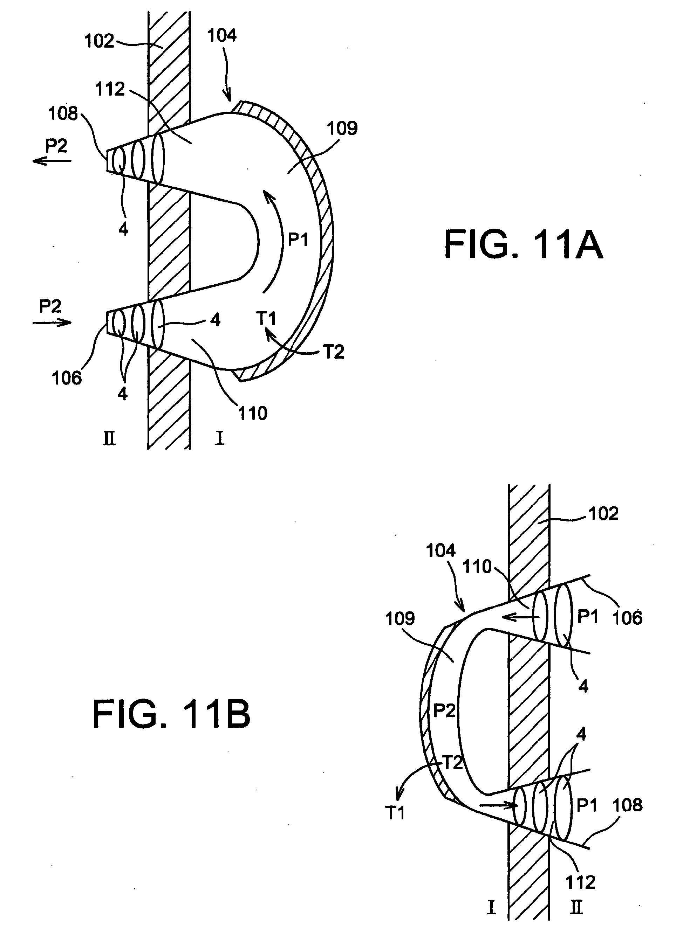

Sur les figures 11A et 11B, on peut voir un autre mode de réalisation d'une pompe à chaleur selon la présente invention, se distinguant notamment de la pompe à chaleur de la figure 8 par le fait que le système est ouvert.

L'exemple de pompe à chaleur représenté sur la figure 11A est destiné à former un système de climatisation d'une zone intérieure I séparée d'une zone extérieure II par un mur 102.

La pompe à chaleur comporte un conduit 104 muni de deux extrémités 106, 108, les deux extrémités du conduit étant situées dans la zone extérieure II et le conduit 104 traverse le mur 102 en deux endroits et chemine dans la zone intérieure I.

La pompe à chaleur comporte également une zone d'échange thermique 109 avec la zone intérieure I. En outre, selon l'invention le dispositif comporte un système de déplacement des gouttes par électromouillage ou par des forces électromagnétiques de gouttes de liquide tel que décrit précédemment, et une unité de commande du déplacement des gouttes aptes à provoquer la variation de pression du fluide pneumatique confiné entre les gouttes.

Dans l'exemple représenté, le conduit 102 comporte des parties d'extrémité 110, 112 dont le profil offre à section variable, plus particulièrement la partie d'extrémité 110 par laquelle l'air pénètre dans le conduit 102 présente une section continûment croissante et la partie d'extrémité 112 par laquelle l'air sort du conduit 102 présente une section continument décroissante.

Nous allons maintenant expliquer le fonctionnement de cette pompe à chaleur formant un système de climatisation.

La pression de l'air dans la zone extérieure est P2. La température de l'air de la zone intérieure est T2.

L'air de la zone extérieure II est confiné entre des gouttes de liquide 4, par exemple au moyen d'un dispositif de la figure 7.

Les gouttes sont entraînées par le système de déplacement, entrainant l'air. Du fait de la forme évasée de la partie d'entrée, l'air confiné entre les gouttes 4 se détend progressivement au fur et à mesure de son déplacement dans la partie d'extrémité 110 du conduit 104 pour atteindre la pression P1. Sa température baisse et est égale à T1 inférieure à T2.

Le gaz à la température T1 atteint alors la zone d'échange thermique 102, la température de la zone intérieure T2 étant supérieure à T1, l'air de la zone intérieure I perd des calories au profit du gaz dans le conduit 104.

Les gouttes poursuivent leur déplacement entraînant avec elles l'air réchauffé. Les gouttes et le gaz entrent ensuite dans la partie d'extrémité 112 d'évacuation où le gaz subit une compression du fait de la réduction de la section de la partie d'extrémité d'évacuation pour atteindre la pression P2 de la zone extérieure. L'air est ensuite relâché dans la zone extérieure.

La maîtrise de la pression dans la zone d'échange thermique 109 est rendue possible grâce à la compression dans la partie d'extrémité 212. Plus généralement, en maîtrisant l'écoulement du gaz en sortie du conduit, on maîtrise la pression et la température en amont de la sortie.

Sur la figure 11B, on peut voir une pompe à chaleur formant un système de chauffage. Dans ce cas, l'air collecté dans la zone extérieure II est comprimé, sa température s'élève. Il échange ensuite ses calories avec la zone intérieure I, puis est détendu et évacué vers la zone extérieure.

En outre, la partie d'extrémité d'entrée 110 du gaz offre une section décroissante pour comprimer le gaz et la partie d'extrémité d'évacuation 112 offre une section croissante pour détendre le gaz.

Il est bien entendu que les conduits peuvent être de section constante, la variation de pression étant obtenue par variation de la distance inter-goutte pour détendre ou comprimer le gaz, comme pour les autres modes de réalisation.

Le fonctionnement est similaire à celui de la pompe à chaleur de la figure 11A, il ne sera donc pas décrit en détail.

Il est bien entendu que l'emplacement de l'échangeur thermique n'est pas limitatif.

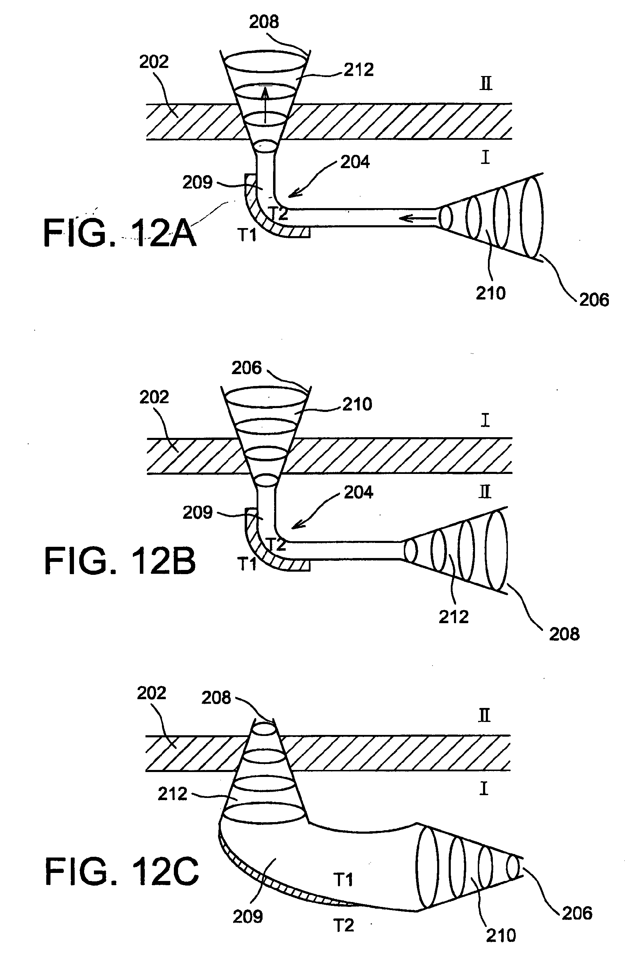

Sur les figures 12A à 12C, on peut voir un autre mode de réalisation de pompe à chaleur, dont le fonctionnement prévoit un échange d'air entre la zone intérieure I et la zone extérieure II.

Sur la figure 12A, la pompe à chaleur forme un système de chauffage, elle est donc destinée à apporter de la chaleur à la zone intérieure I.

La pompe à chaleur comporte un conduit 204 dont une première extrémité 206 ouverte est située dans la zone intérieure I à réchauffer et une deuxième extrémité 206 ouverte est située dans la zone extérieure II.

La pompe à chaleur comporte également un système de déplacement des gouttes par électromouillage ou par des forces électromagnétiques de gouttes de liquide, et une unité de commande du déplacement des gouttes aptes à provoquer la variation de pression de l'air confiné entre les gouttes.

Le conduit comporte une première partie d'extrémité 210 dans la zone intérieure I forme un compresseur d'air, une zone intermédiaire d'échange de chaleur 209 avec la zone intérieure I et une deuxième partie d'extrémité 212 de détente de l'air.

Dans l'exemple représenté la compression et la détente sont obtenues par variation de la section des parties d'extrémité des conduits.

Nous allons expliquer le fonctionnement du mode de réalisation de la figure 12A. L'air dans la zone intérieure est à T1.

L'air intérieur est aspiré par la première extrémité 206 et est confiné entre des gouttes de liquide, par exemple par le dispositif de la figure 7. Les gouttes sont déplacées et entraînent l'air qui est comprimé du fait de la forme de la première partie d'extrémité 210.

La température de l'air augmente progressivement pour atteindre la température T2 supérieure à T1. L'air circule ensuite dans la zone d'échange thermique 209, la température T1 dans la zone intérieure étant inférieure à la température T2 de l'air dans le conduit 204, l'air dans le conduit 204 cède des calories à la zone intérieure. Les gouttes poursuivent leur déplacement et entrent la deuxième partie d'extrémité 212 où l'air subit une détente avant d'être évacué vers la zone extérieure II. Lors de la détente, l'air est freiné et une partie de l'énergie mécanique est convertie en énergie électrique, comme expliqué précédemment.

Il est bien entendu que l'on prévoit, par ailleurs, un système pour introduire de l'air dans la zone intérieure I.

Sur la figure 12B, on peut voir une pompe à chaleur formant un système de climatisation.

Dans ce cas, l'air est aspiré de la zone extérieure II, puis il est comprimé, sa température augmente, dans la zone d'échange thermique 209, l'air comprimé cède des calories à la zone extérieure II, puis cet air subit une détente, sa température est abaissée, et est envoyé dans la zone intérieure I qu'il refroidit.

Sur la figure 12C, on peut voir un autre exemple de pompe à chaleur fonctionnant en climatiseur, où on extrait l'air de la zone intérieure I. Dans ce cas, l'air de la zone intérieure I est aspirée par la pompe à chaleur, est détendu, sa température baisse, en traversant la zone d'échange thermique 209, il absorbe des calories de la zone intérieure I, puis subit une compression avant d'être évacuée vers la zone extérieure.

Ce mode de réalisation présente l'avantage de former un système de circulation d'air entre l'intérieur et l'extérieur.

Il est bien entendu que suivant l'ordre de compression et détente et les zones dans lesquelles l'air est aspiré et rejeté, on réalise des systèmes de refroidissement ou de chauffage.

Il est bien entendu que les pompes à chaleur représentées sur les figures 11A à 12C peuvent comporter plusieurs zones de compression, de détente et d'échange thermique.

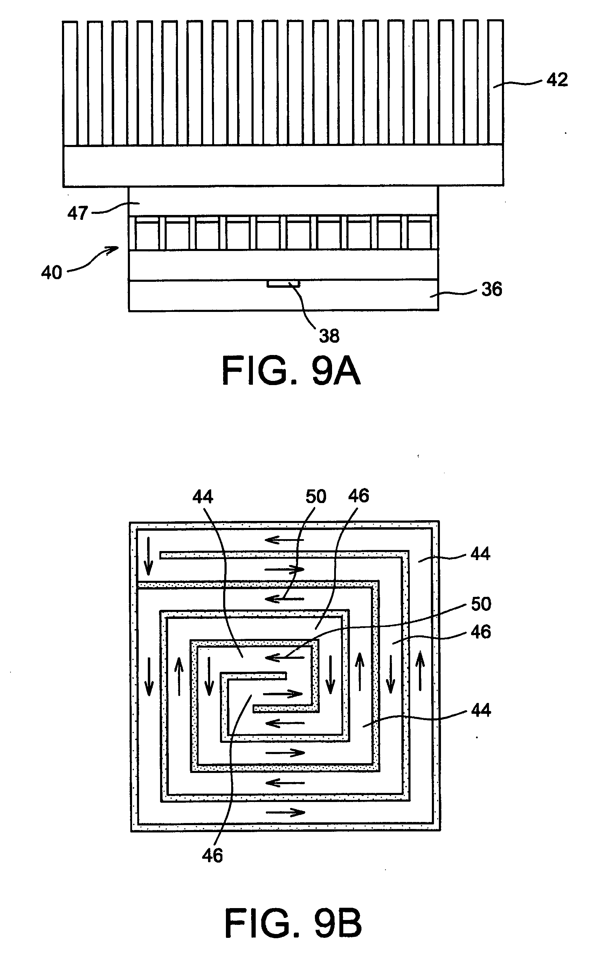

Sur les figures 9A à 9C, on peut voir un exemple d'application de la présente invention à un dispositif de refroidissement pour une puce électronique.

Pour refroidir des puces électroniques, on dispose sur celles-ci de manière connu un radiateur pour faciliter l'échange thermique avec l'extérieur.

Une puce électronique présente une forme plane, le radiateur étant en contact avec une des faces planes de la puce. Une puce électronique est composée d'une pluralité de transistors remplissant chacun une fonction, certains de ces transistors fonctionnent tout le temps comme ceux liés à l'horloge et d'autres ne fonctionnent qu'à certains moments. Par conséquent, certains transistors chauffent énormément tandis que d'autres chauffent très peu, pour ces derniers le radiateur est suffisant. Cependant pour ceux chauffant énormément, le radiateur ne permet pas une évacuation très efficace des calories. En effet, les calories à évacuées étant très localisées, le flux thermique est très localisé dans le radiateur, et la grande surface d'échange du radiateur n'est que très partiellement utilisée.

Grâce à la présente invention, il est possible de répartir de manière plus homogène les calories à dissiper sur toute la surface du radiateur.

Sur la figure 9A, on peut voir une puce électronique 36 avec une point chaud critique 38, un dispositif pour évacuer les calories selon la présente invention 40, et un radiateur 42.

Comme on peut le voir sur la figure 9B, le dispositif pour évacuer les calories 40 comporte deux canaux 44, 46, en forme de spirales centrées sur le point chaud 38, le canal 44 entourant le canal 46.

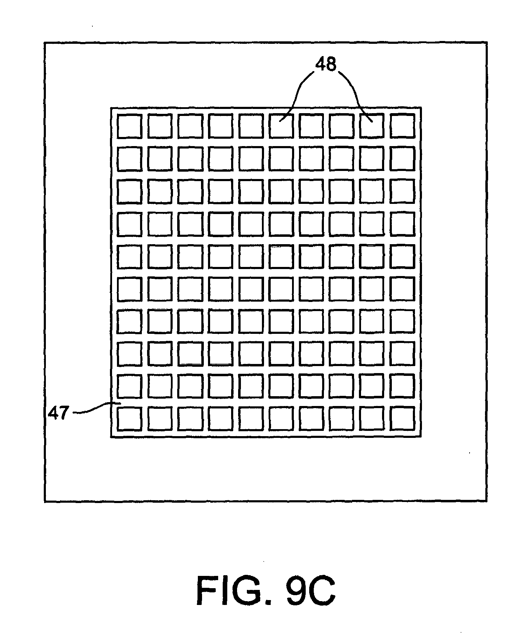

Sur la figure 9C, on peut voir la face supérieure 47 du dispositif de refroidissement formant le plafond du dispositif 40. Dans cet exemple, le déplacement des gouttes s'effectuent par électromouillage. On pourrait utiliser un déplacement par force électromagnétique et un liquide ayant des propriétés ferromagnétiques. Le plafond comporte des électrodes de déplacement 48 disposés en damier de sorte à être en regard des canaux 44, 46. Ces électrodes 48 sont isolées électriquement des gouttes de liquide par le dépôt d'une couche qui soit, à la fois électriquement isolante et hydrophobe vis-à-vis des gouttes, ou le dépôt d'une couche électriquement isolante, par exemple comme une couche de silicium non dopé sur laquelle est déposée une couche de Téflon®.

L'électrode de référence est formée, soit directement par le fond des canaux, si ceux-ci sont légèrement conducteurs, soit par un dépôt d'un conducteur dans le fond des canaux ou sur leur paroi. On peut, par exemple dans le cas où les canaux sont en silicium, doper une partie des canaux. La taille de la zone conductrice peut être très fine par rapport à la largeur des canaux.

On prévoit, comme dans les autres exemples de réalisation, d'avoir des surfaces très hydrophobes par rapport aux gouttes de liquide pour réduire les pertes par frottement, par exemple par dépôt d'une couche de Téflon®.

Des gouttes de liquide sont disposées dans les canaux et sont déplacés au moyen des électrodes de déplacement, comme décrit précédemment, les gouttes sont séparées par un gaz.

Nous allons maintenant décrire le fonctionnement de ce dispositif de refroidissement.

La partie centrale du dispositif, en particulier du canal 44 forme un échangeur thermique, le gaz piégé entre deux gouttes absorbe des calories du point chaud.

Les gouttes circulent dans le canal 44 dans le sens des flèches 50, ensuite ce gaz va subir une compression par rapprochement des gouttes.

Dans la partie la plus extérieure du canal 44 ainsi que dans celle du canal 46, le gaz évacue ensuite des calories vers l'environnement extérieur.

Le gaz subit ensuite une détente jusqu'à se retrouver au niveau du point chaud pour subir un nouveau cycle.

Grâce au dispositif selon l'invention, il y a une répartition des calories à évacuer sur toute la surface de radiateur, puisque le fluide chemine sous tout le radiateur. En outre, il y a également une évacuation latérale des calories par la partie extérieure du canal.

Plus les canaux 44, 46 passent à proximité des transistors à refroidir, plus le dispositif est efficace.

On peut également prévoir de réaliser des canaux dans deux plans différents, un plan coté puce électronique dans lequel on extrait les calories, et un plan coté radiateur dans lequel elles sont évacuées vers l'extérieur via le radiateur. Dans ce cas, les calories, en plus d'être transportées du centre vers les bordures, sont absorbées sur l'ensemble de la surface et éloignées verticalement de la puce électronique, ce qui améliore encore le refroidissement.

Le dispositif de refroidissement peut être réalisé, par exemple en face arrière de la puce électronique à refroidir en gravant en profondeur la partie en silicium, ou en creusant les canaux directement dans une surépaisseur d'isolant déposé sur la puce électronique. On peut également prévoir de graver une plaque en silicium et de reporter celle-ci sur la puce.

Il est bien entendu que les différentes configurations des électrodes de déplacement et leur commande associée s'appliquent à ce dispositif de refroidissement.

La pompe à chaleur selon l'invention peut réaliser d'autres types de cycles thermodynamiques que celui de Joule-Brayton, elle peut permettre de réaliser par exemple le cycle de Carnot ditherme, le cycle de Beau de Rochas et le cycle de Stirling. Ceci est rendu possible par le fait que la présente invention permet de régler les valeurs pression d'un gaz en circulation en tout point de l'espace, points de l'espace qui peuvent être considérés à une température fixe, au niveau des échangeurs thermiques, ou au contraire être considérés complètement isolés thermiquement, au niveau des compresseurs et détendeurs.

Le circuit selon l'invention utilisé comme pompe à chaleur, peut également fonctionner comme générateur d'énergie électrique à partir d'une différence de température. Dans ce cas, il suffit que l'écart de température à générer soit supérieur à l'écart de température qui serait réalisé par les surpressions/sous pression en mode isolé thermiquement. En effet dans ce cas, l'application du gradient de température extérieur a tendance non pas à réduire, mais à augmenter l'écart de température entre les zones en surpression et en sous pression, ce qui permet de restituer plus de travail mécanique lors de la phase de mise en dépression que ce qui est consommé dans la phase de mise en pression.

Le principe de fonctionnement reste alors le même que dans le cas de la pompe à chaleur, la différence porte uniquement sur le signe de $\varepsilon$. En effet, pour que le milieu extérieur apporte de l'énergie au système, la température du canal du coté chaud est à T1-$|\varepsilon|$ au lieu de T1+$|\varepsilon|$ et réciproquement du coté froid la température est à T2+$|\varepsilon|$ as lieu de T2-$|\varepsilon|$.

Le rendement de Carnot étant cette fois-ci directement proportionnel à l'écart de température absorbé, il est avantageux de le maximiser or celui-ci est égale à T1-T2-2$|\varepsilon|$. Il est donc, comme dans le cas de la pompe à chaleur, intéressant de minimiser, en valeur absolue, la valeur de $\varepsilon$ et dans le même temps de le maintenir constant tout le long de l'échangeur pour maximiser le flux thermique et donc la quantité d'énergie thermique convertie.

Dans le cas de la récupération d'énergie électrique, les phases de compression et de détente sont encore présentes. Pour la compression, un apport d'énergie électrique est requis pour forcer le déplacement des gouttes et augmenter la pression du gaz entre D et C. Par contre dans la phase de détente, au lieu de faire avancer les gouttes par apport d'énergie électrique, celles-ci sont freinées, cette énergie de freinage est transformée en énergie électrique. La puissance électrique consommée pour augmenter la pression entre D et C, qui est égale à Puissance Apportée = Gain En Pression*Débit, est largement compensée par l'énergie récupérée lors de la détente, qui est égale à Puissance Récupérée = Perte En Pression*Débit. En effet, le débit de gaz est plus important lors de la détente que lors de la compression puisque le volume de gaz a augmenté du fait de l'augmentation de température. La puissance récupérable correspond en fait à la différence de débit entre la détente et la compression multipliée par la différence de pression entre le coté chaud et froid, cette différence de pression étant liée à la différence de température recherchée : T1-T2-2$|\varepsilon|$.

La goutte de liquide lorsque qu'elle se déplace, est en contact avec l'électrode de référence et forme une électrode mobile par rapport à l'électrode de déplacement. L'ensemble électrode de déplacement, la couche diélectrique, et la goutte de liquide forme donc un condensateur à capacité variable.

En effet, dans un condensateur la relation entre la charge (Q), la capacité (C) et la tension (V) entre les électrodes est la suivante :

$$Q = C \times V \qquad (1),$$

et
l'énergie est donnée par la relation suivante :

$$E = \frac{1}{2}QV \qquad (2),$$

Une diminution de capacité à charge constante provoque par conséquent une augmentation de la tension V, et donc une augmentation de l'énergie E.

En mettant en mouvement les gouttes dans la zone D à C, par exemple par électromouillage les gouttes arrivent dans la zone CB d'échange thermique. Le gaz inter-goutte s'échauffe dans la zone CD, de ce fait les gouttes s'écartent. Les gouttes sont alors en avance de phase dans la zone BA. La goutte forme donc avec l'électrode de déplacement précédente, un condensateur à capacité variable. En injectant et en retirant une charge lorsque la capacité du condensateur est maximale et minimale respectivement, il est possible de récupérer une énergie électrique. En fait, on convertie l'énergie de freinage de la goutte en énergie électrique.

Les modes de pilotages décrits dans le cadre d'un fonctionnement en pompe à chaleur peuvent être appliqués exactement de la même manière dans le cadre de la génération d'énergie électrique à la différence prés qu'il faut que les pressions dans les échangeurs cotés chaud et froid conduisent à une température légèrement inférieure à T1 coté chaud et légèrement supérieure à T2 coté froid.

La présente invention peut être appliquée dans de nombreux domaines, et notamment :

- dans les systèmes de chauffage ou de climatisation dans le bâtiment (chauffage par pompe à chaleur), comme cela a été décrit en détail,
- dans les machines frigorifiques,
- dans le refroidissement des composants électroniques,
- pour l'analyse chimique ou biologique, par exemple dans le cas de bactéries baignant dans les gouttes liquides et pouvant suivre des cycles de température souhaités,
- dans le domaine de la récupération de l'énergie d'un gradient thermique en imposant la différence de température, l'énergie électrique restituée lors du passage de la zone chaude à la zone froide est alors supérieure à l'énergie électrique apportée pour passer de la zone froide à la zone chaude.

**Revendications**

1. Dispositif de variation de la pression d'un fluide pneumatique, comportant un canal dans lequel circule une pluralité de gouttes (4) de fluide hydraulique distantes les unes des autres, et des moyens de déplacement des dites gouttes dans le canal, lesdits moyens de déplacement mettant en oeuvre soit des forces électrostatiques au moyen d'une électrode de référence (3) avec laquelle les gouttes sont en contact permanent et d'une pluralité d'électrodes de déplacement (8, 8', 8") discrètes aptes à être mises à un potentiel variable, soit lesdits moyens de déplacement mettant en oeuvre des forces électromagnétiques au moyen d'une pluralité de générateurs (104. 1, 104.2, 104.3) de champ magnétique, **caractérisé en ce que** ledit fluide pneumatique est confiné de manière étanche entre les gouttes (4) de fluide hydraulique, les forces appliquées par lesdits moyens de déplacement (3, 8, 8', 8", 104. 1, 104.2, 104.3) étant telles que le volume entre les gouttes augmente ou diminue progressivement selon un sens de déplacement (12) donné provoquant respectivement une compression ou une détente du fluide pneumatique de manière progressive, ledit dispositif comportant au moins un premier (10.1), un deuxième (10.2) et un troisième (10.3) volume de fluide pneumatique successifs, et une unité de commande appliquant une commande aux électrodes (8, 8', 8") de déplacement ou aux générateurs (104. 1, 104.2, 104.3) de champ magnétique pour provoquer le rapprochement ou l'écartement des gouttes (4) dans le sens (12) de déplacement des gouttes (4), de sorte que la pression du fluide pneumatique augmente ou diminue progressivement du premier (10.1) au troisième (20.3) volume de fluide pneumatique.

2. Dispositif de variation de la pression d'un fluide pneumatique selon la revendication 1, par déplacement au moyen de forces électrostatiques, les électrodes de déplacement (8', 8") étant regroupées par groupe (G1, G2, G3) de n électrodes se succédant dans le sens de déplacement des gouttes, une unité de commande appliquant une commande identique à chacun des groupes (G1, G2, G3) pour provoquer le rapprochement ou l'écartement des gouttes (4) dans le sens (12) de déplacement des gouttes (4).

3. Dispositif de variation de la pression d'un fluide pneumatique selon la revendication 2, la distance séparant les électrodes de déplacement se réduisant ou augmentant de manière monotone dans le sens de déplacement (12) des gouttes (4), lesdits moyens de déplacement étant commandés par une tension à n phases, n étant par exemple égal à 3.

4. Dispositif de variation de la pression d'un fluide pneumatique selon la revendication 3, dans lequel lesdites électrodes de déplacement (8') sont de dimension variable de manière monotone dans le sens (12) de déplacement des gouttes.

5. Dispositif de variation de la pression d'un fluide pneumatique selon la revendication 1, par déplacement au moyen de forces électromagnétiques, lesdits générateurs (104. 1, 104.2, 104.3) étant regroupés par groupe de n générateurs se succédant dans le sens de déplacement des gouttes, une unité de commande appliquant une commande identique à chacun des groupes pour provoquer le rapprochement ou l'écartement des gouttes dans le sens de déplacement des gouttes.

6. Dispositif de variation de la pression d'un fluide pneumatique selon la revendication 5, dans lequel la distance séparant lesdits générateurs (104. 1, 104.2, 104.3) se réduit dans le sens de déplacement des gouttes, lesdits moyens de déplacement étant commandés par une tension à n phases, n étant par exemple égal à 3.

7. Dispositif de variation de la pression d'un fluide pneumatique selon l'une des revendications 1 à 6, dans lequel la surface intérieure du canal est non mouillante vis-à-vis des gouttes, i.e. une surface hydrophobe dans le cas d'une solution aqueuse, et une surface oléophobe dans le cas d'un corps gras.

8. Pompe à chaleur comportant au moins deux dispositifs selon l'une des revendications 1 à 7, au moins l'un comportant une unité de commande telle qu'il forme un compresseur (18) du fluide pneumatique, au moins un autre comportant une unité de commande telle qu'il forme un détendeur (22) du fluide pneumatique, ladite pompe à chaleur comportant également au moins un échangeur thermique (16, 109) reliant le compresseur (18) au détendeur (22), ledit au moins compresseur (18), ledit au moins détendeur (22), et ledit au moins échangeur thermique (16, 109) formant un canal unique.

9.   Pompe à chaleur selon la revendication précédente, dans laquelle l'extrémité à haute pression du compresseur (18) est connectée à l'extrémité haute pression du détendeur (22) par l'intermédiaire d'un échangeur thermique (20) d'une source chaude (5C), et l'extrémité basse pression du détendeur (22) est connectée à l'extrémité basse pression du compresseur (18) par un échangeur thermique (16) avec une source froide (SF), l'ensemble formé par le compresseur (18), le détendeur (22), et les échangeurs thermiques (16, 20) formant un canal unique, les pressions du fluide pneumatique dans les échangeurs thermiques (16, 20) étant telles que la température du fluide pneumatique dans l'échangeur thermique (20) de la source chaude (SC) est supérieure à une première température, et la température du fluide pneumatique dans l'échangeur thermique (16) de la source froide (SF) est inférieure à une deuxième température,

10.   Pompe à chaleur selon la revendication 8 ou 9, dans laquelle les échangeurs thermiques (16, 20) sont formés par des canaux munis de moyens de déplacement mettant en oeuvre des forces électrostatiques ou des forces électromagnétiques, chacun de ces échangeurs (16, 20) comportant une unité de commande pour maîtriser la pression et la température du fluide pneumatique confiné entre les gouttes, les échangeurs thermiques (16, 20) comportant avantageusement des capteurs de flux permettant à l'unité de commande de régler le déplacement des gouttes pour maintenir un flux thermique sensiblement constant.

11.   Pompe à chaleur selon l'une des revendications 8 à 10, dans laquelle les dispositifs formant compresseur (18) et détendeur (22) comportent des capteurs de flux thermique sur la paroi des canaux afin de mesurer le flux thermique entre le canal et l'extérieur, l'unité de commande étant apte à agir sur les moyens de déplacement pour réduire la valeur absolue du flux thermique, de sorte à obtenir des compressions et détentes sensiblement adiabatiques.

12.   Pompe à chaleur selon l'une des revendications 8 à 11, comportant des moyens de calibrages des gouttes dans le circuit et leurs dispositions relatives, lesdits moyens de calibrage comportant un réservoir (24) muni d'un orifice d'admission des gouttes usagées et d'un orifice d'alimentation du circuit des gouttes renouvelées, et des moyens de formation (30) de gouttes par électromouillage, le réservoir (24) collectant les gouttes usagées, les moyens de formation (30) de gouttes utilisant le fluide hydraulique collecté pour former de nouvelles gouttes.

13.   Pompe à chaleur selon la revendication 8, dans laquelle le canal (104) est ouvert et comporte deux extrémités ouvertes (106, 108), et dans laquelle les deux extrémités ouvertes (106, 108) communiquent soit avec la source chaude, soit avec la source froide, le fluide pneumatique subissant la détente et la compression étant de l'air pris dans la source chaude ou la source froide, et l'échangeur thermique (109) échangeant des calories avec la source froide ou la source chaude, ou dans laquelle l'une des extrémités ouvertes est située dans la source chaude et l'autre extrémité ouverte est située dans la source froide, le fluide pneumatique étant l'air qui est aspiré de la source chaude ou la source froide et est relâché dans la source froide ou la source chaude respectivement, l'échangeur thermique (109) étant situé dans la source chaude ou la source froide, de sorte qu'il y ait un échange d'air entre la source chaude et la source froide.

14.   Pompe à chaleur comprenant

        - un dispositif de variation de pression selon l'une des revendications 1 à 7
        - un détendeur formé par une partie du canal du dispositif de variation de pression,
        - un compresseur formé par une autre partie du canal du dispositif de variation de pression ; et
        - un échangeur thermique reliant le compresseur au détendeur,

        ledit dispositif de variation de pression comportant également une unité de commande des moyens de déplacement, les commandes émises par l'unité de commande étant telles que le volume entre les gouttes augmente progressivement dans la partie du canal correspondant au compresseur ou diminue progressivement dans une partie du canal correspondant au détendeur, provoquant ainsi une compression et une détente du fluide pneumatique entre les deux points du canal, le compresseur, le détendeur, et l'échangeur thermique formant un canal unique.

15.   Système de refroidissement d'une puce électronique comportant une pompe à chaleur selon l'une des revendications 8 à 14.

16.   Système de refroidissement d'une puce électronique (36) selon la revendication précédente en combinaison avec la revendication 9, dans lequel le canal unique de la pompe à chaleur est formé en face arrière de ladite puce, le canal (44, 46) unique étant formé par une première spirale (44) formant l'échangeur thermique avec la source froide formée par la puce et le compresseur, et une deuxième spirale (46) formant l'échangeur thermique avec la source chaude formée par l'environnement extérieur et le détendeur, la première spirale entourant la deuxième spirale, le système de refroidissement comportant un radiateur (42) sur la pompe à chaleur à l'opposé de la puce électronique (36), le canal unique serpentant sous le radiateur (42)" la première spirale (44) permet un échange thermique directement avec l'environnement extérieur, en plus de l'échange avec le radiateur (42).

17. Dispositif de conversion d'une énergie thermique en énergie électrique comportant au moins deux dispositifs selon l'une des revendications 1 à 7, l'un comportant une unité de commande telle qu'il forme un compresseur du fluide pneumatique, l'autre comportant une unité de commande telle qu'il forme un détendeur du fluide pneumatique, l'extrémité à haute pression du compresseur étant connectée à l'extrémité haute pression du détendeur par l'intermédiaire d'un échangeur thermique d'une source chaude à une première température, et l'extrémité basse pression du détendeur étant connectée à l'extrémité basse pression du compresseur par un échangeur thermique avec une source froide à une deuxième température, l'ensemble formé par le compresseur, le détendeur, et les échangeurs thermiques formant un canal unique, les pressions du fluide pneumatique dans les échangeurs thermiques étant telles que la température du fluide pneumatique dans l'échangeur thermique de la source chaude est inférieure à la première température, et la température du fluide pneumatique dans l'échangeur thermique de la source froide est supérieure à la deuxième température.

18. Dispositif de conversion d'une énergie thermique en énergie électrique selon la revendication 17, dans laquelle les échangeurs thermiques sont formés par des canaux munis de moyens de déplacement mettant en oeuvre des forces électrostatiques ou des forces électromagnétiques, chacun des ces échangeurs comportant une unité de commande pour maîtriser la pression et la température du fluide pneumatique confiné entre les gouttes.

**Patentansprüche**

1. Vorrichtung zur Veränderung des Drucks eines Pneumatikfluids, einen Kanal, in dem eine Vielzahl voneinander beabstandeter Hydraulikfluid-Tropfen (4) fließt, und Verschiebungseinrichtungen der genannten Tropfen in dem Kanal umfassend, wobei die Verschiebungseinrichtungen entweder elektrostatische Kräfte anwenden, mittels einer Referenzelektrode (3), mit der die Tropfen permanent Kontakt haben, und einer Vielzahl diskreter Verschiebungselektroden (8, 8', 8"), an die ein variables Potential gelegt werden kann, oder die genannten Verschiebungseinrichtungen elektromagnetische Kräfte anwenden, mittels einer Vielzahl von Magnetfeld-Generatoren (104.1, 104.2, 104.3),
**dadurch gekennzeichnet, dass** das genannte Pneumatikfluid auf dichte Weise eingeschlossen ist zwischen den Pneumatikfluid-Tropfen (4), wobei die durch die genannten Verschiebungseinrichtungen (3, 8, 8', 8", 104.1, 104.2, 104.3) angewendeten Kräfte so sind, dass das Volumen zwischen den Tropfen progressiv zunimmt oder abnimmt entsprechend einer bestimmten Verschiebungsrichtung (12), was jeweils auf progressive Weise eine Kompression oder eine Expansion verursacht, wobei die genannte Vorrichtung sukzessiv wenigstens ein erstes (10.1), ein zweites (10.2) und ein drittes (10.3) Pneumatikfluid-Volumen umfasst, und eine Steuerungseinheit, die den Verschiebungselektroden (8, 8', 8") oder den Magnetfeldgeneratoren (104.1, 104.2, 104.3) einen Befehl erteilt, um den Abstand zwischen den Tropfen (4) in der Verschiebungsrichtung (12) der Tropfen (4) zu verkleinern oder zu vergrößern, so dass der Druck des Pneumatikfluids vom ersten (10.1) bis zum dritten (10.3) Pneumatikfluid-Volumen zunimmt oder abnimmt.

2. Vorrichtung zur Veränderung des Drucks eines Pneumatikfluids nach Anspruch 1, durch Verschiebung mittels elektrostatischer Kräfte, wobei die Verschiebungselektroden (8', 8") zusammenfasst sind zu Gruppen (G1, G2, G3) von n in der Verschiebungsrichtung der Tropfen aufeinanderfolgenden Elektroden und eine Steuerungseinheit jeder der Gruppen (G1, G2, G3) einen identischen Befehl erteilt, um den Abstand zwischen den Tropfen (4) in der Verschiebungsrichtung (12) der Tropfen (4) zu verkleinern oder zu vergrößern.

3. Vorrichtung zur Veränderung des Drucks eines Pneumatikfluids nach Anspruch 2, wobei der Abstand zwischen den Verschiebungselektroden sich in der Verschiebungsrichtung (12) der Tropfen (4) monoton verkleinert oder vergrößert, wobei die Verschiebungseinrichtungen durch eine Spannung mit n Phasen gesteuert werden und n dabei zum Beispiel gleich 3 ist.

4. Vorrichtung zur Veränderung des Drucks eines Pneumatikfluids nach Anspruch 3, bei der die genannten Verschiebungselektroden (8') in der Verschiebungsrichtung (12) der Tropfen auf monotone Weise von variabler Dimension sind.

5. Vorrichtung zur Veränderung des Drucks eines Pneumatikfluids nach Anspruch 1, durch Verschiebung mittels elektrostatischer Kräfte, wobei die genannten Generatoren (104.1, 104.2, 104.3) zusammenfasst sind zu Gruppen von n in der Verschiebungsrichtung der Tropfen aufeinanderfolgenden Generatoren und eine Steuerungseinheit jeder der Gruppen einen identischen Befehl erteilt, um den Abstand zwischen den Tropfen in der Verschiebungsrichtung der Tropfen zu verkleinern oder zu vergrößern.

6. Vorrichtung zur Veränderung des Drucks eines Pneumatikfluids nach Anspruch 5, bei der der die genannten Generatoren (104.1, 104.2, 104.3) trennende Abstand in der Verschiebungsrichtung der Tropfen abnimmt, wobei die genannten Verschiebungseinrichtungen durch eine Spannung mit n Phasen gesteuert werden und n dabei zum Beispiel gleich 3 ist.

7. Vorrichtung zur Veränderung des Drucks eines Pneumatikfluids nach einem der Ansprüche 1 bis 6, bei der die Innenoberfläche des Kanals gegenüber den Tropfen unbenetzbar ist, das heißt im Falle einer wässrigen Lösung eine hydrophobe Oberfläche ist und im Falle eines Fettstoffs eine oleophobe Oberfläche ist.

8. Wärmepumpe mit wenigstens zwei Vorrichtungen nach einem der Ansprüche 1 bis 7, wobei wenigstens die Eine eine Steuerungseinheit in Form einer Einrichtung (18) zur Verdichtung des Pneumatikfluids umfasst und wenigstens eine andere eine Steuerungseinheit in Form einer Entspannungseinrichtung (22) des Pneumatikfluids, wobei die genannte Wärmepumpe ebenfalls wenigstens einen Wärmetauscher (16, 109) umfasst, der die Verdichtungseinrichtung (18) und die Entspannungseinrichtung (22) verbindet, und die genannte wenigstens eine Verdichtungseinrichtung (18), die genannte wenigstens eine Entspannungseinrichtung (22) und der genannte wenigstens eine Wärmetauscher (16, 109) einen einzigen Kanal bilden.

9. Wärmepumpe nach dem vorhergehenden Anspruch, bei der das Hochdruck-Ende der Verdichtungseinrichtung (18) durch einen Wärmetauscher (20) einer Wärmequelle (SC) mit dem Hochdruck-Ende der Entspannungseinrichtung (22) verbunden ist, und das Niederdruck-Ende der Entspannungseinrichtung (22) durch einen Wärmetauscher (16) mit einer Kältequelle (SF) mit dem Niederdruck-Ende der Verdichtungseinrichtung (18) verbunden ist, wobei die durch die Verdichtungseinrichtung (18), die Entspannungseinrichtung (22) und die Wärmetauscher (16, 20) gebildete Einheit einen einzigen Kanal bildet, und die Drücke der Pneumatikfluide in den Wärmetauschern (16, 20) so sind, dass die Temperatur des Pneumatikfluids in dem Wärmetauscher (20) der Wärmequelle (SC) höher ist als eine erste Temperatur, und die Temperatur des Pneumatikfluids in dem Wärmetauscher (16) der Kältequelle (SF) niedriger ist als eine zweite Temperatur.

10. Wärmepumpe nach Anspruch 8 oder 9, bei der die Wärmetauscher (16, 20) durch Kanäle gebildet werden, ausgerüstet mit Verschiebungseinrichtungen, die elektrostatische Kräfte oder elektromagnetische Kräfte anwenden, wobei jeder dieser Wärmetausche (16, 20) zur Beherrschung des Drucks und der Temperatur des zwischen den Tropfen eingeschlossenen Pneumatikfluids eine Steuerungseinheit umfasst, und die Wärmetauscher (16, 20) vorteilhafterweise Flusssensoren umfassen, die der Steuerungseinheit ermöglichen, die Verschiebung der Tropfen zu regeln, um einen im Wesentlichen konstanten Wärmefluss aufrecht zu erhalten.

11. Wärmepumpe nach einem der Ansprüche 8 bis 10, bei der die die Verdichtungs- und Entspannungseinrichtung (18 ; 22) bildenden Einrichtungen auf der Wand der Kanäle Wärmeflusssensoren umfassen, um den Wärmefluss zwischen dem Kanal und der Außenseite zu messen, wobei die Steuerungseinheit fähig ist, auf die Verschiebungseinrichtungen einzuwirken, um den Absolutwert des Wärmeflusses zu reduzieren, so dass man im Wesentlichen adiabatische Kompressionen und Expansionen erhält.

12. Wärmepumpe nach einem der Ansprüche 8 bis 11, umfassend : Kalibrierungseinrichtungen der Tropfen in dem Kreislauf und ihre relativen Dispositionen, wobei die genannten Kalibrierungseinrichtungen ein Reservoir (24) mit einer Einlassöffnung der gebrauchten Tropfen und eine Einspeisöffnung der Erneuerungstropfen aufweisen, und Einrichtungen (30) zur Tropfenbildung durch Elektrobenetzung, das die gebrauchten Tropfen sammelnde Reservoir (24), die das zu Bildung neuer Tropfen gesammelte Hydraulikfluid benutzenden Tropfenbildungseinrichtungen (30).

13. Wärmepumpe nach Anspruch 8, bei der der Kanal (104) offen ist und zwei offene Enden (106, 108) umfasst, und bei der die beiden offenen Enden (106, 108) entweder mit der Wärmequelle oder mit der Kältequelle kommunizieren, wobei das der Expansion und der Kompression ausgesetzte Pneumatikfluid aus der Wärmequelle oder der Kältequelle entnommene Luft ist, und der Wärmetauscher (109) mit der Kältequelle oder der Wärmequelle Kalorien austauscht, oder bei der eines der offenen Enden sich in der Wärmequelle befindet und das andere offene Ende sich in der Kältequelle befindet, wobei das Pneumatikfluid Luft ist, die jeweils aus der Wärmequelle oder der Kältequelle angesaugt wird und in die Kältequelle oder die Wärmequelle entlassen wird, wobei der Wärmetauscher (109) sich in der Wärmequelle oder der Kältequelle befindet, so dass ein Luftaustausch zwischen der Wärmequelle und der Kältequelle stattfindet.

14. Wärmepumpe, umfassend :

- eine Druckveränderungsvorrichtung nach einem der Ansprüche 1 bis 7,
- eine Entspannungseinrichtung, gebildet durch einen Teil des Kanals der Druckveränderungsvorrichtung,
- eine Verdichtungseinrichtung, gebildet durch einen anderen Teil des Kanals der Druckveränderungsvorrichtung ; und
- einen die Verdichtungseinrichtung und die Entspannungseinrichtung verbindenden Wärmetauscher,

wobei die genannte Druckveränderungsvorrichtung auch eine Steuerungseinheit der Verschiebungseinrichtungen umfasst und dabei die durch die Steuerungseinheit erteilten Befehle so sind, dass das Volumen zwischen den Tropfen in dem Teil des Kanals, der der Verdichtungseinrichtung entspricht, progressiv zunimmt, und in einem Teil des Kanals, der der Entspannungseinrichtung entspricht, progressiv abnimmt, was eine Kompression und eine Expansion des Pneumatikfluids zwischen den beiden Punkten des Kanals bewirkt, wobei die Verdichtungseinrichtung, die Entspannungseinrichtung und der Wärmetauscher einen einzigen Kanal bilden.

15. Kühlsystem eines IC-Chips, eine Wärmepumpe nach einem der Ansprüche 8 bis 14 umfassend.

16. Kühlsystem eines IC-Chips (36) nach dem vorhergehenden Anspruch in Kombination mit dem Anspruch 9, bei dem der einzige Kanal der Wärmepumpe auf der Rückseite des genannten Chips ausgebildet ist, der einzige Kanal (44, 46) gebildet wird durch eine erste Spirale (44), die den Wärmetauscher mit der Kältequelle bildet, gebildet durch den Chip und die Verdichtungseinrichtung, und eine zweite Spirale (46), die den Wärmetauscher mit der Wärmequelle bildet, gebildet durch die Außenumgebung und die Entspannungseinrichtung, wobei die erste Spirale die zweite Spirale umgibt, das Kühlsystem einen Radiator (42) auf der Wärmepumpe umfasst, auf der dem IC-Chip (36) entgegengesetzten Seite, und der einzige Kanal schlangenförmig unter dem Radiator (42) verläuft und die erste Spirale (44) einen direkten Wärmeaustausch mit der Außenumgebung ermöglicht, zusätzlich zu dem Austausch mit dem Radiator (42).

17. Vorrichtung zu Umwandlung einer thermischen Energie in elektrische Energie, wenigstens zwei Vorrichtungen nach einem der Ansprüche 1 bis 7 umfassend, wobei die eine eine Steuerungseinheit in Form einer Einrichtung zur Verdichtung des Pneumatikfluids umfasst und die andere eine Steuerungseinheit in Form einer Entspannungseinrichtung des Pneumatikfluids umfasst, wobei das Hochdruck-Ende der Verdichtungseinrichtung durch einen Wärmetauscher einer Wärmequelle mit einer ersten Temperatur mit dem Hochdruck-Ende der Entspannungseinrichtung verbunden ist, und das Niederdruck-Ende der Entspannungseinrichtung durch einen Wärmetauscher mit einer Kältequelle mit einer zweiten Temperatur mit dem Niederdruck-Ende der Verdichtungseinrichtung verbunden ist, wobei die durch die Verdichtungseinrichtung, die Entspannungseinrichtung und die Wärmetauscher gebildete Einheit einen einzigen Kanal bildet, und die Drücke der Pneumatikfluide in den Wärmetauschern so sind, dass die Temperatur des Pneumatikfluids in dem Wärmetauscher der Wärmequelle niedriger ist als die erste Temperatur, und die Temperatur des Pneumatikfluids in dem Wärmetauscher der Kältequelle höher ist als die zweite Temperatur.

18. Vorrichtung zu Umwandlung einer thermischen Energie in elektrische Energie nach Anspruch 17, bei der die Wärmetauscher durch Kanäle gebildet werden, die Verschiebungseinrichtungen umfassen, die elektrostatische oder elektromagnetische Kräfte anwenden, wobei jeder der Wärmetauscher eine Steuerungseinheit umfasst, um den Druck und die Temperatur des zwischen den Tropfen eingeschlossenen Pneumatikfluids zu beherrschen.

**Claims**

1. A device for varying the pressure of a fluid, comprising a channel in which travel multiple droplets (4) of hydraulic fluid which are at some distance from one another, and means for displacement of said droplets in the pipe, the means of displacement using electrostatic by means of a reference electrode (3) with which the droplets are in permanent contact and of a plurality of displacement electrodes (8, 8', 8"),or electromagnetic forces by means of multiple magnetic field generators (104.1, 104.2, 104.3), **characterized in that** said driven fluid is a pneumatic fluid confined in airtight fashion between the droplets (4) of hydraulic fluid, and wherein the forces applied by said means of displacement ((8, 8', 8", 104.1, 104.2, 104.3) are such that the volume between the droplets increases or is reduced gradually in a given displacement direction, respectively causing a compression or an expansion of the pneumatic fluid in a gradual manner, and a control unit applying a control to displacement electrodes (8, 8', 8") or to magnetic field generators (104.1, 104.2, 104.3)to cause lesser or greater distance between the droplets (4) in the direction of displacement (12) of the droplets (4) in order to increase or reduce progressively the pressure of the pneumatic fluid from the first volume (10.1) to the third volume (10.3) of pneumatic fluid.

2. A device to vary the pressure of a pneumatic fluid according to claim 1, through displacement by means of electrostatic forces, the displacement electrodes (8', 8") being grouped in groups (G1, G2, G3) of n electrodes succeeding one another in the displacement direction of the droplets, a control unit applying an identical control to each of the groups (G1, G2, G3) in order to cause lesser or greater distance between the droplets (4) in the direction of displacement (12) of the droplets (4).

3. A device to vary the pressure of a pneumatic fluid according to claim 2, where the distance separating the displacement electrodes is lessened or increased in an unvarying fashion in the direction of displacement (12) of the droplets (4), where said means of displacement are controlled by a n-phase voltage with, n being for example equal to 3.

4. A device for varying the pressure of a pneumatic fluid according to claim 3, in which said displacement electrodes (8') are of a variable dimension in an unvarying fashion in the direction (12) of displacement of the droplets.

5. A device for varying the pressure of a pneumatic fluid according to claim 1, through displacement by means of electromagnetic forces, said generators being grouped into groups of n generators succeeding one another in the displacement direction of the droplets, a control unit applying an identical control to each of the groups to cause greater closeness or greater distance between the droplets in the displacement direction of the droplets.

6. A device to vary the pressure of a pneumatic fluid according to claim 5, where the distance separating said generators is lessened in the direction of displacement of the droplets, and where said means of displacement are controlled by a n-phase voltage with, n being for example equal to 3.

7. A device for varying the pressure of a pneumatic fluid according to one of the claims 1 to 6, in which the inner surface of the pipe is non-wetting with regard to the droplets, i.e. a hydrophobic surface in the case of an aqueous solution, and an oleophobic surface in the case of a greasy substance.

8. A heat pump comprising at least two devices according to one of the claims 1 to 7, where at least one comprises a control unit such that it forms a compressor (18) of the pneumatic fluid, where at least one other device comprises a control unit such that it forms an expander (22) of the pneumatic fluid, where said pump also comprises at least one thermal exchanger linking the compressor to the expander, and where said at least one compressor, said at least one expander and said at least one thermal exchanger form a single channel.

9. A heat pump according to the previous claim, in which the high-pressure end of the compressor (18) is connected to the high-pressure end of the expander (22) through a thermal exchanger (20) of a hot source (SC), and the low-pressure end of the expander (22) is connected to the low-pressure end of the compressor (18) through a thermal exchanger (16) with a cold source (SF), where the unit formed by the compressor (18), the expander (22) and the thermal exchangers (16, 20) forms a single channel, where the pressures of the pneumatic fluid in the thermal exchangers are such that the temperature of the pneumatic fluid in the thermal exchanger of the hot source is higher than a first temperature, and the temperature of the pneumatic fluid in the thermal exchanger of the cold source is lower than a second temperature.

10. A heat pump according to claim 8 or 9, in which the thermal exchangers (16, 20) are formed by pipes with means for displacement using electrostatic forces or electromagnetic forces, where each of these exchangers (16, 20) comprises a control unit to control the pressure and temperature of the pneumatic fluid confined between the droplets, the thermal exchangers (16, 22) advantageously comprising flow sensors enabling the control unit to adjust the displacement of the droplet to maintain a thermal flow which is essentially constant.

11. A heat pump according to one of the claims 8 to 10, in which the devices forming the compressor (18) and the expander (22) comprise thermal flow sensors on the walls of the pipes in order to measure the thermal flow between the pipe and the outside, where the control unit is able to act on the means of displacement to reduce the absolute value of the thermal flow, so as to obtain compressions and expansions which are essentially adiabatic.

12. A heat pump according to one of the claims 8 to 11, comprising means for calibrating the droplets in the circuit and their relative positions, said means of calibration comprise a tank (24) with an orifice to let in the used droplets and an orifice for supply of the circuit of renewed droplets, and means for forming (30) droplets by electro-wetting, where the tank (24) collects the used droplets, and the means for formation (30) of droplets uses the collected hydraulic fluid to form a new droplets.

13. A heat pump according to claim 8, in which the channel is open and comprises two open ends (106, 108) and in which the two open ends (106, 108) communicate either with the hot source, or with the cold source, and where the pneumatic fluid is subject to the expansion, and where the compression is of air taken from the hot source or the cold source, and where the thermal exchanger exchanges heat with the cold source or the hot source or in which one of the open ends is located in the hot source and the other end in the cold source, and where the pneumatic fluid is the air which is drawn in from the hot source or the cold source, and is released into the cold source or the hot source, respectively, and where the thermal exchanger is located in the hot source or the cold source, such that there is an exchange of air between the hot source and the cold source.

14. A heat pump comprising

   - A device for varying the pressure according to one of claims 1 to 7,
   - an expander formed by apportion of the channel of the device for varying the pressure,
   - a compressor formed by another portion of the channel of the device for varying the pressure, and
   - a thermal exchanger linking the compressor to the expander

   said device for varying the pressure also comprising a unit for controlling the means of displacement, where the commands issued by the control unit are such that the volume between the droplets gradually increases in a part of the channel corresponding to the compressor, or gradually reduces in a part of the channel corresponding to the expander, thus causing a compression and an expansion of the pneumatic fluid between the two points of the channel, and where the compressor, the expander and the thermal exchanger form a single channel.

15. A system for cooling an electronic chip comprising a heat pump according to one of the claims 8 to 14.

16. A system for cooling an electronic chip (36) according to the previous claim in combination with claim 9, in which the single channel of the heat pump is formed in the rear face of said chip, where the single channel (44, 46) is formed by a first spiral (44) forming the thermal exchanger with the cold source formed by the chip and the compressor, where a second spiral (46) forms the thermal exchanger with the hot source formed by the external environment and the expander, where the first spiral surrounds the second spiral, and where the cooling system comprises a radiator (42) on the heat pump on the opposite side of the electronic chip (36), with the single channel winding under the radiator (42).

17. A device for converting thermal energy into electrical energy comprising at least two devices according to one of the claims 1 to 7, one comprising a control unit such that it forms a compressor of the pneumatic fluid, where the high-pressure end of the compressor is connected to the high-pressure end of the expander through a thermal exchanger of a hot source at a first temperature, and where the low-pressure end of the expander is connected to the low-pressure end of the compressor by a thermal exchanger with a cold source at a second temperature, where the unit formed by the compressor, the expander and the thermal exchangers forms a single channel, and where the pressures of the pneumatic fluid in the thermal exchangers are such that the temperature of the pneumatic fluid in the thermal exchanger of the hot source is lower than the first temperature, and the temperature of the pneumatic fluid in the thermal exchanger of the cold source is higher than the second temperature.

18. A device for converting thermal energy into electrical energy according to claim 17, in which the thermal exchangers are formed by pipes fitted with means for displacement using electrostatic forces or electromagnetic forces, where each of these exchangers comprises a control unit to control the pressure and temperature of the pneumatic fluid confined between the droplets.

**FIG. 1**

**FIG. 1'**

**FIG. 2**

FIG. 3A

FIG. 3B

FIG. 4

| | $t_1$ | $t_2$ | $t_3$ | $t_4$ | $t_5$ | $t_6$ | $t_7$ | $t_8$ | $t_9$ | $t_{10}$ |
|---|---|---|---|---|---|---|---|---|---|---|
| $V_1$ | V | 0 | V | V | 0 | 0 | V | 0 | 0 | V |
| $V_2$ | V | V | 0 | V | V | 0 | 0 | V | 0 | 0 |
| $V_3$ | 0 | V | V | 0 | V | V | 0 | 0 | V | 0 |
| $V_4$ | 0 | 0 | V | V | 0 | V | V | 0 | 0 | V |
| $V_5$ | V | 0 | 0 | V | V | 0 | V | V | 0 | 0 |
| $V_6$ | 0 | V | 0 | 0 | V | V | 0 | V | V | 0 |
| $V_7$ | 0 | 0 | V | 0 | 0 | V | V | 0 | V | V |
| $V_8$ | V | 0 | 0 | V | 0 | 0 | V | V | 0 | V |
| $V_9$ | V | V | 0 | 0 | V | 0 | 0 | V | V | 0 |
| $V_{10}$ | 0 | V | V | 0 | 0 | V | 0 | 0 | V | V |

FIG. 5

FIG. 6A

FIG. 6B

FIG. 6C

FIG. 6D

FIG. 7

FIG. 8

**FIG. 9A**

**FIG. 9B**

FIG. 9C

G1    G2    G3

104.1  104.2  104.3

# FIG. 10A

104.1    104.2    102    104.3

4

106

# FIG. 10B

FIG. 11A

FIG. 11B

FIG. 12A

FIG. 12B

FIG. 12C

## RÉFÉRENCES CITÉES DANS LA DESCRIPTION

**Documents brevets cités dans la description**

- US 6318970 B

- FR 2841063

**Littérature non-brevet citée dans la description**

- **M.G. POLLACK ; A.D. SHENDOROV ; R.B. FAIR.** Electro-wetting-based actuation of droplets for integrated microfluidics. *Lab Chip,* 2002, vol. 2 (1), 96-101

- **ROLAND BAVIÈRE ; JÉRÔME BOUTET ; YVES FOUILLET.** Dynamics of droplet transport induced by electrowetting actuation. *Microfluid Nanofluid,* Avril 2008, vol. 4 (4